(19) Europäisches Patentamt / European Patent Office / Office européen des brevets

(11) **EP 3 255 682 B1**

(12) **EUROPEAN PATENT SPECIFICATION**

(45) Date of publication and mention of the grant of the patent:
**04.11.2020 Bulletin 2020/45**

(21) Application number: **16746711.7**

(22) Date of filing: **05.02.2016**

(51) Int Cl.:
**H01L 31/05** (2014.01)     **H01L 31/048** (2014.01)

(86) International application number:
**PCT/JP2016/053461**

(87) International publication number:
**WO 2016/125880 (11.08.2016 Gazette 2016/32)**

(54) **WIRING SHEET, STRUCTURE, AND PHOTOVOLTAIC GENERATION MODULE**

VERDRAHTUNGSPLATTE, STRUKTUR UND FOTOVOLTAISCHES ERZEUGUNGSMODUL

FEUILLE D'INTERCONNEXION, STRUCTURE ET MODULE DE GÉNÉRATION PHOTOVOLTAÏQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **06.02.2015 JP 2015022069**

(43) Date of publication of application:
**13.12.2017 Bulletin 2017/50**

(73) Proprietor: **DOW-MITSUI POLYCHEMICALS CO., LTD.**
**Minato-ku**
**Tokyo 1057122 (JP)**

(72) Inventors:
• **ISOKAWA, Motoaki**
  **Ichihara-shi**
  **Chiba 299-0108 (JP)**
• **ENDO, Yui**
  **Tokyo 1057122 (JP)**
• **SATO, Norihiko**
  **Ichihara-shi**
  **Chiba 299-0108 (JP)**
• **ICHINOSEKI, Chikara**
  **Ichihara-shi**
  **Chiba 299-0108 (JP)**
• **NAKATA, Kazuyuki**
  **Ichihara-shi**
  **Chiba 299-0108 (JP)**

(74) Representative: **Gulde & Partner**
**Patent- und Rechtsanwaltskanzlei mbB**
**Wallstraße 58/59**
**10179 Berlin (DE)**

(56) References cited:
WO-A1-2014/045909     JP-A- 2000 186 114
JP-A- 2000 243 990     JP-A- 2004 308 033
JP-A- 2005 536 894     JP-A- 2012 138 467
JP-A- 2012 209 462     JP-A- 2014 015 544
US-A1- 2005 241 692     US-A1- 2012 255 610

**Description**

TECHNICAL FIELD

The present invention relates to a wiring sheet, a structure, and a photovoltaic generation module.

BACKGROUND ART

Generally, on a photovoltaic generation module, a semiconductor element (photovoltaic generation element) changing light energy into electric energy is mounted. In a typical photovoltaic generation module of the related art, in order to inhibit the decrease in power generation properties of the module, the photovoltaic generation element is sealed with a resin sheet, for the purpose of preventing the photovoltaic generation element from contacting external air, preventing an impact from being exerted on the photovoltaic generation element, and the like. In order for light energy to be efficiently supplied to the photovoltaic generation element, the resin sheet is required to have transparency. As the material forming the resin sheet, from the viewpoint of transparency, flexibility, adhesiveness, tensile strength, weather fastness, cost balance, and the like, an ethylene-vinyl acetate copolymer (EVA) has been suitably used.

In recent years, the technology level required for various properties of the photovoltaic generation module has become increasingly heightened. Particularly, in recent years, for the photovoltaic generation module, the improvement of power generation efficiency, cost reduction, and the like have been increasingly required. In order to satisfy the requirements, various examinations are conducted regarding the constitution of the resin sheet.

As a technique focused on the constitution of the resin sheet, for example, there is a technique described below.

Patent Document 1 discloses a resin sealing sheet which contains an ethylene-vinyl acetate copolymer (EVA) and an ultraviolet absorber and is treated with ionizing radiation. Patent Document 3 discloses photovoltaic modules containing solar cells having at least one polymeric optically transparent encapsulant layer with solar energy weighted transmittance at wavelengths of light from 350 to 1200 nanometers equal to or greater than 85% and ultra-violet light cutoff equal to or less than 345 nanometers.

Patent Document 4 discloses a solar cell module having multiple solar cells on which five or more tub lines are formed. In Patent Document 5 an electrode is described for contacting an electrically conductive surface, in particular for contacting at least one surface of a photovoltaic element wafer.

RELATED DOCUMENT

PATENT DOCUMENT

[Patent Document 1] Japanese Unexamined Patent Application Publication No.2014-141542
[Patent Document 2] Japanese Unexamined Patent Application Publication No.2011-210891
[Patent Document 3] US 20120255610 A1
[Patent Document 4] WO 2014045909 A1
[Patent Document 5] US 20050241692 A1

SUMMARY OF THE INVENTION

For the aforementioned resin sheet of the related art, the constitution containing an ultraviolet absorber is adopted. Therefore, in view of long-term durability obtained by inhibiting the deterioration of the resin caused by ultraviolet rays, the resin sheet is expected to be effective to a certain extent. In this way, for the resin sheet of the related art, in order to realize the long-term durability of the resin sheet, a constitution is adopted in which the light of a region of a wavelength of less than 380 nm, that is, ultraviolet rays are prevented from entering the photovoltaic generation element. Consequently, in view of improving the power generation efficiency of the photovoltaic generation module, the resin sheet has a limitation.

In the light of the circumstances described above, currently, in order to further improve the power generation efficiency, there is a strong demand for a photovoltaic generation module having a constitution which enables the light energy derived from visible light as well as the light energy derived from ultraviolet rays to change into electric energy.

In recent years, in order to obtain a resin sheet, which inhibits the deterioration of a resin caused by ultraviolet rays due to long-term use described above and can use the light energy derived from ultraviolet rays, various examinations have been conducted regarding a technique for incorporating a wavelength converting agent such as a fluorescent substance into the resin sheet (Patent Document 2 and the like). However, the inventors of the present invention obtained knowledge that in the resin sheet containing the wavelength converting agent, when the wavelength of the incident ultraviolet rays is converted, a trace of light energy is lost.

An object of the present invention is to provide a wiring sheet which enables the light energy derived from ultraviolet rays to efficiently contribute to power generation, and a structure and a photovoltaic generation module including the wiring sheet.

Solution to Problem

Considering the issue of cost reduction which has been required in recent years for photovoltaic generation modules, the inventors of the present invention conducted thorough examinations regarding resin materials usable in a wiring sheet which does not deteriorate even when being irradiated with ultraviolet rays for a long period of time. As a result, the inventors obtained knowledge that the properties of the wiring sheet subtly vary with the combination of various factors such as the type of the resin used, the density of the resin, the melt flow rate of the resin, the cross-linked state of the resin, and the type and amount of additives mixed in. Therefore, it was difficult to generalize and specify the characteristics of the resin material for forming the wiring sheet according to the present invention of the present application.

Accordingly, in order to obtain a wiring sheet which enables the light energy derived from ultraviolet rays to efficiently contribute to power generation, the inventors of the present invention conducted thorough examinations. As a result, the inventors obtained knowledge that a parameter which is a light transmittance of a resin sheet at a wavelength of 350 nm is effective as a design guide, and accomplished the present invention.

According to the present invention, there is provided a wiring sheet for a photovoltaic module including a resin sheet and fine wires provided on one surface of the resin sheet, in which a light transmittance, which may be measured based on JIS-K7105, of the resin sheet at a wavelength of 350 nm is equal to or higher than 70%, wherein the resin sheet is formed of a resin material containing any of the following (A) and (B).

(A) Ionomer of copolymer containing ethylene and unsaturated carboxylic acid or ionomer of the copolymer
(B) Copolymer containing ethylene and (meth)acrylic acid glycidyl.

According to the present invention, there is also provided a structure including the wiring sheet and a sealing material formed of a resin material containing any of the following (A) and (B).

(A) Copolymer containing ethylene and unsaturated carboxylic acid or ionomer of the copolymer
(B) Copolymer containing ethylene and (meth)acrylic acid glycidyl

According to the present invention, there is also provided a photovoltaic generation module including a light-transmitting substrate and the wiring sheet.

Advantageous Effects of Invention

According to the present invention, it is possible to provide a wiring sheet, which enables the light energy derived from ultraviolet rays to efficiently contribute to power generation, and a structure and a photovoltaic generation module including the wiring sheet.

BRIEF DESCRIPTION OF THE DRAWINGS

The aforementioned object, other objects, characteristics, and advantages are further clarified by the suitable embodiments described below and the following drawings attached thereto.

Fig. 1 is an example of a cross-sectional view showing a wiring sheet according to a first embodiment.
Fig. 2 is an example of a plan view showing the wiring sheet according to the first embodiment.
Fig. 3 is an example of a cross-sectional view showing a structure according to the first embodiment.
Fig. 4 is an example of a cross-sectional view showing a photovoltaic generation module according to the first embodiment.
Fig. 5 is an example of a cross-sectional view showing a wiring sheet according to a second embodiment.
Fig. 6 is an example of a schematic cross-sectional view showing a layered structure of a photovoltaic generation module according to the second embodiment.

## DESCRIPTION OF EMBODIMENTS

(First embodiment)

<<Wiring sheet 100>>

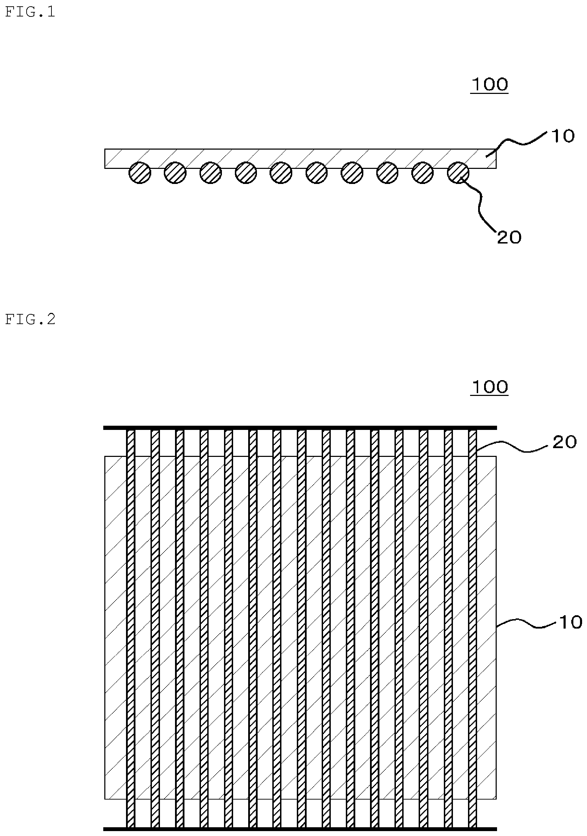

Fig. 1 is an example of a cross-sectional view showing a wiring sheet 100 according to the present embodiment.

As shown in Fig. 1, the wiring sheet 100 according to the present embodiment includes a resin sheet 10 and fine wires 20 provided on one surface of the resin sheet 10. The light transmittance, measured based on JIS-K7105, of the resin sheet 10 at a wavelength of 350 nm is equal to or higher than 70%. By adopting the aforementioned constitution, it is possible to realize the wiring sheet 100 which enables the light energy derived from ultraviolet rays to efficiently contribute to power generation.

In the present embodiment, the light energy derived from ultraviolet rays refers to light energy derived from light of a region of a wavelength of less than 380 nm.

As described above in the section of Background Art, in recent years, the improvement of power generation efficiency, cost reduction, and the like have been highly required for photovoltaic generation modules. In the light of the circumstances described above, in recent years, in order to realize a photovoltaic generation module which enables the light energy derived from visible light as well as the light energy derived from ultraviolet rays to change into electric energy, various examinations have been conducted regarding a technique for incorporating a wavelength converting agent such as a fluorescent substance into a resin sheet. However, the inventors of the present invention obtained knowledge that even if the wavelength converting agent is incorporated into the resin sheet, when the wavelength of the incident ultraviolet rays is converted, a trace of light energy is lost. Specifically, the inventors of the present invention obtained knowledge that in a case where a resin sheet containing a wavelength converting agent of the related art is used, power collection loss occurs in which a portion of the light energy derived from the incident ultraviolet rays cannot be converted into electric energy.

Generally, a resin sheet, which is used for sealing a photovoltaic generation element in a photovoltaic generation module and prepared on the premise of being disposed on a light-receiving surface (incidence surface) side of the photovoltaic generation module, is required to demonstrate six performances listed below. The first required performance is transparency for transmitting more light. The second required performance is flexibility for preventing cracking of the photovoltaic generation element. The third required performance is adhesiveness that enables the photovoltaic generation element and the resin sheet to be in a state of coming into close contact with each other to such an extent that the air of the exterior of the photovoltaic generation module can be prevented from entering and contacting the photovoltaic generation element. The fourth required performance is tensile strength of such an extent that the resin can be prevented from expanding or contracting due to a temperature change in an environment in which the photovoltaic generation module is used. The fifth required performance is weather fastness of such an extent that the resin material can be inhibited from deteriorating due to ultraviolet rays. The sixth required performance is long-term moist-heat resistance of such an extent that the performance deterioration of failure of the photovoltaic generation element can be prevented at the time of using the photovoltaic generation module.

As described above, for the wiring sheet 100 according to the present embodiment, a constitution is adopted in which the resin sheet 10 can transmits light at a wavelength of 350 nm in a specific amount or more. Therefore, the wiring sheet 100 according to the present embodiment makes it possible to use the light energy derived from ultraviolet rays without converting the wavelength of the incident ultraviolet rays. By adopting the aforementioned constitution, it is possible to realize a photovoltaic generation module of which the power generation efficiency is further improved compared to the resin sheet of the related art. It goes without saying that the wiring sheet 100 according to the present embodiment satisfies the six properties described above.

In the wiring sheet 100 according to the present embodiment, the light transmittance, measured based on JIS-K7105, of the resin sheet 10 at a wavelength of 350 nm is equal to or higher than 70%, preferably equal to or higher than 75%, and more preferably equal to or higher than 80%. In a case where the light transmittance is as described above, the light energy derived from ultraviolet rays can be caused to more effectively contribute to power generation.

In the wiring sheet 100 according to the present embodiment, a total light transmittance of the resin sheet 10 measured based on JIS-K7105 is preferably equal to or higher than 80%, and more preferably equal to or higher than 85%. In a case where the total light transmittance is as described above, not only the ultraviolet light but also the light in various wavelength regions can be caused to efficiently contribute to power generation. For measuring the total light transmittance based on JIS-K7105, white light rays including ultraviolet light, visible light, and infrared light are used.

<Fine wires 20>

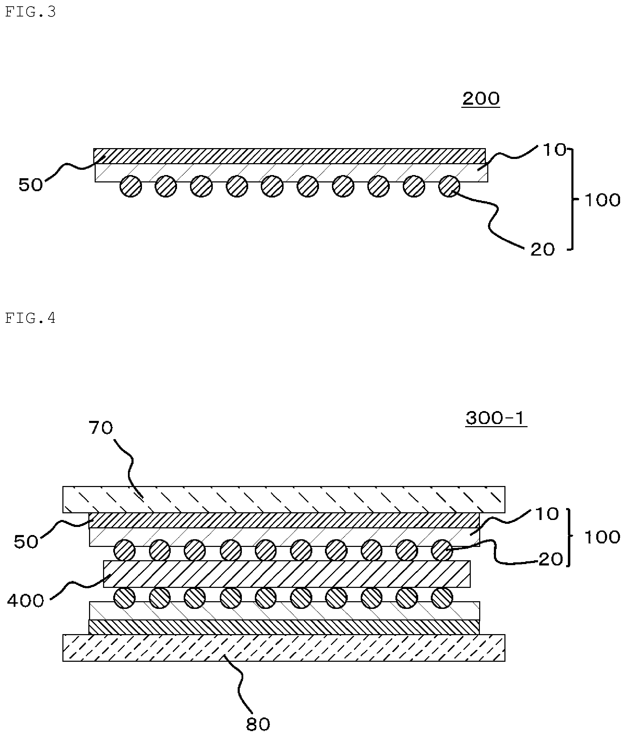

As shown in Fig. 1, in the wiring sheet 100, a portion of the fine wires 20 is preferably buried in the resin sheet 10. In a case where this constitution is adopted, the fine wires 20 and the resin sheet 10 can be in a strongly bonded state. Therefore, it is possible to reduce the influence resulting from the impact exerted on a photovoltaic generation element 400 (see Fig. 4) which is in a state of being sealed using the wiring sheet 100.

Fig. 2 is an example of a plan view showing the wiring sheet 100 according to the present embodiment.

From the viewpoint of reducing the cost of the photovoltaic generation module, the fine wires 20 in the wiring sheet 100 according to the present embodiment are preferably formed of a plurality of wires disposed in parallel with each other as shown in Fig. 2. In a case where this constitution is adopted, the amount of a metal material used for forming the fine wires 20 can be reduced. Examples of the metal material forming the fine wires 20 include silver, copper, indium, tin, and the like. Among these, indium, tin, or an alloy of indium and tin is preferable. From the viewpoint of power collection efficiency, the wires forming the fine wires 20 preferably have a diameter of equal to or greater than 50 $\mu$m and equal to or less than 500 $\mu$m, and more preferably have a diameter of equal to or greater than 100 $\mu$m and equal to or less than 300 $\mu$m.

<Resin sheet 10>

As described above in the section of Solution to Problem, the properties of the wiring sheet 100 according to the present embodiment vary with the combination of various factors such as the type of the resin used, the density of the resin, the melt flow rate of the resin, the cross-linked state of the resin, and the type and amount of additives formulated with the resin. The resin sheet 10 in the wiring sheet 100 is formed of a resin material containing any of (A) ionomer of copolymer of ethylene and unsaturated carboxylic acid and (B) copolymer containing ethylene and (meth)acrylic acid glycidyl (referred to as glycidyl (meth)acrylate as well). In a case where this constitution is adopted, the wiring sheet 100 can be realized which makes it difficult for the resin to deteriorate due to ultraviolet rays even when the photovoltaic generation module is used for a long period of time. It is considered that because all of the aforementioned resin materials are highly transparent resins, are not easily influenced by ultraviolet rays, and are excellent in mechanical properties such as tensile strength, the wiring sheet 100 having the properties characteristics may be obtained. Therefore, in a case where the composition of the formulation of the aforementioned resin material is highly controlled, the resin sheet 10 which enables the light energy derived from ultraviolet rays to efficiently contribute to power generation is highly likely to be realized. The resin materials forming the resin sheet 10 will be specifically described later.

Regarding the resin sheet 10, the Shore D hardness of the material forming the resin sheet 10 that is measured under the condition of room temperature (25°C) based on JIS-K7125 by using a type D durometer is preferably higher than 25 and equal to or lower than 200, more preferably equal to or higher than 30 and equal to or lower than 200, even more preferably equal to or higher than 45 and equal to or lower than 200, and still more preferably equal to or higher than 48 and equal to or lower than 100. In a case where the Shore D hardness is within the above range, in the photovoltaic generation module, it is possible to reduce the influence resulting from the impact exerted on the photovoltaic generation element 400 that is in a state of being sealed using the wiring sheet 100. Therefore, according to the wiring sheet 100 including the resin sheet 10 of which the Shore D hardness measured for a specific region under a specific condition is within the aforementioned range of numerical values, the durability of the photovoltaic generation module can be improved. Furthermore, when being formed in the resin sheet 10, the fine wires 20 can be buried in the resin sheet 10 under appropriate control. Accordingly, when being used in a photovoltaic generation module, the wiring sheet 100 can be excellently connected to the photovoltaic generation element 400. As a result, by the wiring sheet 100 according to the present embodiment, the power generation efficiency can be further improved.

Regarding the resin sheet 10, a storage modulus E' of the material forming the resin sheet 10 at a temperature of 60°C is preferably equal to or higher than 1 MPa and equal to or lower than 1,000 MPa, more preferably equal to or higher than 10 MPa and equal to or lower than 1,000 MPa, and even more preferably equal to or higher than 20 MPa and equal to or lower than 500 MPa. In a case where the storage modulus E' is within the above range, in the photovoltaic generation module, it is possible to reduce the influence resulting from the impact exerted on the photovoltaic generation element 400 that is in a state of being sealed using the wiring sheet 100, and to adjust the fine wires 20 to be buried within an appropriate range. Therefore, according to the wiring sheet 100 including the resin sheet 10 of which the storage modulus E' measured for a specific region under a specific condition is within the aforementioned range of numerical values, it is possible to improve the durability of the photovoltaic generation module and to improve the power generation efficiency.

Regarding the resin sheet 10, a bending stiffness of the material forming the resin sheet 10 measured under the condition of room temperature (25°C) based on JIS-K7106 is preferably equal to or higher than 10 MPa and equal to or lower than 400 MPa, more preferably equal to or higher than 30 MPa and equal to or lower than 400 MPa, even more preferably equal to or higher than 50 MPa and equal to or lower than 400 MPa, and still more preferably equal to or higher than 100 MPa and equal to or lower than 300 MPa. In a case where the bending stiffness is within the above range, it is possible to more effectively inhibit the resin from expanding or contracting due to a temperature change in an environment in which the photovoltaic generation module is used.

It is preferable that the value of tensile elasticity of the resin sheet 10 that is obtained when a tensile test is performed based on JIS-K7127 under the conditions of 25°C and a loading rate of 200 mm/min satisfies the following conditions. Specifically, provided that a tensile elasticity of the resin sheet 10 in a machine direction (MD) obtained when a tensile test is performed based on JIS-K7127 under the conditions of 25°C and a loading rate of 200 mm/min is $TS_M$, and that a tensile elasticity of the resin sheet 10 in a transverse direction (TD) obtained when a tensile test is performed based on JIS-K7127 under the conditions of 25°C and a loading rate of 200 mm/min is $TS_T$, the value of $TS_M/TS_T$ is preferably equal to or greater than 0.9 and equal to or less than 1.1, and more preferably equal to or greater than 0.95 and equal to or less than 1.05. In a case where the value of $TS_M/TS_T$ is within the above range, uniform tensile properties can be imparted to the entirety of the resin sheet 10. As a result, even in a case where the temperature condition under which the photovoltaic generation module is used rapidly changes, it is possible to effectively inhibit the power generation properties of the photovoltaic generation module from changing due to the expansion or contraction of the resin material.

The moisture permeance of the resin sheet 10 at a temperature of 85°C and 90% RH is preferably equal to or higher than 0 g·mm/m²·day and equal to or lower than 100 g·mm/m²·day, and more preferably equal to or higher than 0 g·mm/m²·day and equal to or lower than 70 g·mm/m²·day. In a case where the moisture permeance is within the above range, it is possible to realize the wiring sheet 100 having much better long-term moist-heat resistance.

Next, the resin material forming the resin sheet 10 according to the present embodiment will be described.

As described above, the resin sheet 10 according to the present embodiment is preferably formed of a resin material containing any of the following (A) and (B).

(A) Copolymer containing ethylene and unsaturated carboxylic acid or ionomer of copolymer containing ethylene and unsaturated carboxylic acid
(B) Copolymer containing ethylene and (meth)acrylic acid glycidyl

The melt flow rate of the resin material forming the resin sheet 10 that is measured based on JIS-K7210-1999 under the conditions of a temperature of 190°C and a load of 2,169 g is preferably equal to or higher than 0.1 g/10 min and equal to or lower than 50 g/10 min, more preferably equal to or higher than 0.5 g/10 min and equal to or lower than 30 g/10 min, and most preferably equal to or higher than 1 g/10 min and equal to or lower than 20 g/10 min. In a case where the melt flow rate is within the above range, the workability of the sheet can be improved. Therefore, at the time of preparing the photovoltaic generation module, it is possible to realize excellent adhesiveness while inhibiting the resin from sticking out.

Examples of the unsaturated carboxylic acid component in the copolymer of ethylene and unsaturated carboxylic acid and the ionomer of the copolymer of ethylene and unsaturated carboxylic acid include acrylic acid, methacrylic acid, ethacrylic acid, fumaric acid, maleic acid, monomethyl maleate, maleic anhydride, and the like. Among these, as the unsaturated carboxylic acid component, (meth)acrylic acid is preferable. Therefore, as the copolymer of ethylene and unsaturated carboxylic acid, an ethylene·(meth) acrylic acid copolymer is preferable. The ethylene·(meth) acrylic acid copolymer according to the present embodiment is not limited to the binary copolymer of ethylene and unsaturated carboxylic acid, and includes a multi-component copolymer containing ethylene and unsaturated carboxylic acid, such as an ethylene·unsaturated carboxylic acid·unsaturated carboxylic acid ester copolymer. Examples of the unsaturated carboxylic acid ester component in the ethylene·unsaturated carboxylic acid·unsaturated carboxylic acid ester copolymer include alkyl esters, having 1 to 20 carbon atoms, of various carboxylic acids used as the aforementioned unsaturated carboxylic acid component. Specifically, examples of the alkyl group include a methyl group, an ethyl group, an n-propyl group, an isopropyl group, an n-butyl group, an isobutyl group, a 2-ethylhexyl group, an isooctyl group, and the like.

From the viewpoint of realizing excellent ultraviolet ray-transmitting properties, the content of the unsaturated carboxylic acid unit such as a (meth) acrylic acid unit in the copolymer of ethylene and unsaturated carboxylic acid or the ionomer thereof according to the present embodiment is preferably equal to or greater than 2% by weight and equal to or less than 30% by weight, more preferably equal to or greater than 4% by weight and equal to or less than 25% by weight, even more preferably equal to or greater than 9% by weight and equal to or less than 25% by weight, and most preferably equal to or greater than 12% by weight and equal to or less than 20% by weight.

In a case where the copolymer contains an unsaturated carboxylic acid ester, the content of the unsaturated carboxylic acid ester with respect to the total amount of the copolymer is preferably equal to or greater than 1% by weight and equal to or less than 35% by weight, more preferably equal to or greater than 3% by weight and equal to or less than 32% by weight, and even more preferably equal to or greater than 5% by weight and equal to or less than 30% by weight.

A metal species derived from an alkali metal such as lithium or sodium, a polyvalent metal such as calcium, magnesium, cerium, zinc, or aluminum, or the like can be incorporated into the ionomer of the copolymer of ethylene and unsaturated carboxylic acid. Among these, sodium, magnesium, and zinc are preferably used. Generally, an ionomer is known to have excellent transparency and have a high storage modulus E' at a high temperature. A degree of neutralization of the ionomer of the copolymer of ethylene and unsaturated carboxylic acid according to the present embodiment is preferably equal to or lower than 80%, more preferably equal to or lower than 60% from the viewpoint of adhesiveness, and most preferably equal to or lower than 40%.

In a case where the resin sheet 10 according to the present embodiment is formed of the copolymer of ethylene and unsaturated carboxylic acid or the ionomer of the copolymer of ethylene and unsaturated carboxylic acid, from the viewpoint of causing the copolymer to exhibit excellent transparency and adhesiveness, the content of the unsaturated carboxylic acid with respect to the total amount of the copolymer is preferably equal to or greater than 1% by weight, more preferably equal to or greater than 2% by weight, and even more preferably equal to or greater than 3% by weight. In contrast, from the viewpoint of reducing hygroscopicity, the content of the unsaturated carboxylic acid with respect to the total amount of the copolymer is preferably equal to or less than 20% by weight, and more preferably equal to or less than 15% by weight.

In a case where the copolymer contains an unsaturated carboxylic acid ester, from the viewpoint of causing the copolymer to exhibit excellent transparency and adhesiveness, the content of the unsaturated carboxylic acid ester with respect to the total amount of the copolymer is preferably equal to or greater than 1% by weight, more preferably equal to or greater than 3% by weight, and even more preferably equal to or greater than 5% by weight. In contrast, in a case where the copolymer contains an unsaturated carboxylic acid ester, from the viewpoint of reducing hygroscopicity, the content of the unsaturated carboxylic acid ester with respect to the total amount of the copolymer is preferably equal to or less than 35% by weight, more preferably equal to or less than 32% by weight, and even more preferably equal to or less than 30% by weight.

In the present embodiment, the melting point of the copolymer of ethylene and unsaturated carboxylic acid is preferably equal to or higher than 55°C, more preferably equal to or higher than 60°C, and most preferably equal to or higher than 70°C. In a case where the melting point is as described above, it is possible to inhibit the deformation of the resin sheet 10 in a case where the temperature increases at the time of using the photovoltaic generation module, and to inhibit the leakage of the resin material or the occurrence of burr at the time of manufacturing the photovoltaic generation module.

The copolymer of ethylene and unsaturated carboxylic acid according to the present embodiment can be obtained by performing a radical copolymerization reaction under the conditions of a high temperature and a high pressure. Furthermore, the ionomer of the copolymer of ethylene and unsaturated carboxylic acid can be obtained by reacting the copolymer of ethylene and unsaturated carboxylic acid with a metal compound.

The (meth)acrylic acid glycidyl contained in the copolymer containing ethylene and (meth)acrylic acid glycidyl contained in the resin sheet 10 according to the present embodiment refers to at least either methacrylic acid glycidyl or acrylic acid glycidyl.

Examples of the copolymer containing ethylene and (meth)acrylic acid glycidyl include one kind of copolymer or two or more kinds of copolymers selected from an ethylene·(meth) acrylic acid glycidyl copolymer, an ethylene·(meth) acrylic acid glycidyl·vinyl acetate copolymer, an ethylene·(meth) acrylic acid glycidyl·(meth)acrylic acid ester copolymer, and the like.

The proportion of a constitutional unit derived from (meth)acrylic acid glycidyl contained in the copolymer containing ethylene and (meth)acrylic acid glycidyl is preferably equal to or higher than 2% by weight and equal to or lower than 30% by weight, and more preferably equal to or higher than 3% by weight and equal to or lower than 25% by weight.

In a case where the proportion of the constitutional unit derived from (meth)acrylic acid glycidyl contained in the copolymer is within the above range, the adhesiveness, the flexibility, the handleability, the workability, and the like of the obtained resin sheet 10 can be balanced much better.

The proportion of "constitutional unit derived from ethylene" contained in the copolymer containing ethylene and (meth)acrylic acid glycidyl is preferably equal to or higher than 65% by weight, more preferably equal to or higher than 70% by weight, and particularly preferably equal to or higher than 80% by weight. At this time, the copolymer containing ethylene and (meth)acrylic acid glycidyl can additionally contain monomer units (for example, vinyl acetate, a (meth)acrylic acid ester, and the like) other than ethylene and (meth)acrylic acid glycidyl.

Specifically, for example, in addition to the copolymer containing the constitutional unit derived from ethylene and the constitutional unit derived from (meth)acrylic acid glycidyl, it is possible to use a copolymer containing the aforementioned two constitutional units and at least either a constitutional unit derived from vinyl acetate or a constitutional unit derived from a (meth)acrylic acid ester.

The proportion of the constitutional unit derived from vinyl acetate and the constitutional unit derived from a (meth)acrylic acid ester contained in the copolymer is preferably equal to or lower than 30% by weight, and more preferably equal to or lower than 20% by weight.

The lower limit of the proportion of the constitutional unit derived from vinyl acetate and the constitutional unit derived from a (meth)acrylic acid ester contained in the copolymer is not particularly limited, but is preferably equal to or higher than 0.1% by weight, more preferably equal to or higher than 0.5% by weight, and even more preferably equal to or higher than 1% by weight. The proportion of the constitutional unit derived from vinyl acetate and the constitutional unit derived from a (meth)acrylic acid ester contained in the copolymer is preferably within a range of 0.1% to 30% by weight, more preferably within a range of 0.5% to 20% by weight, and particularly preferably within a range of 1% to 20% by weight.

One kind of the copolymer containing ethylene and (meth)acrylic acid glycidyl can be used singly. Alternatively, two or more kinds of the copolymer having different copolymerization ratios or two or more kinds of the copolymer containing different monomer species can be used in combination.

At least a portion of the copolymer containing ethylene and (meth)acrylic acid glycidyl may be modified with a silane coupling agent.

The content of the silane coupling agent is preferably 0.01% to 5% by weight with respect to 100% by weight of the copolymer containing ethylene and (meth)acrylic acid glycidyl.

The resin sheet 10 may contain any of (A) and (B) described above. It is preferable that the total content of (A) and (B) with respect to 100% by weight of the resin component in the resin sheet 10 is preferably equal to or greater than 30% by weight, more preferably equal to or greater than 40% by weight, and even more preferably equal to or greater than 50% by weight. The upper limit of the content is not particularly limited, but in a case where the resin sheet 10 contains (B), the upper limit is preferably equal to or less than 80% by weight, and more preferably equal to or less than 60% by weight.

The resin material forming the resin sheet 10 according to the present embodiment may contain other resins. Examples of other resins include a propylene-based resin, an ethylene-based resin, and the like.

Examples of the ethylene-based resin include an ethylene·α-olefin copolymer, an ethylene·polar monomer copolymer, or the like in which the proportion of a constitutional unit derived from an α-olefin having 3 to 20 carbon atoms contained in the copolymer is equal to or higher than 5 mol% and less than 50 mol%.

Specific examples of the α-olefin having 3 to 20 carbon atoms include linear α-olefins such as propylene, 1-butene, 1-pentene, 1-hexene, 1-heptene, 1-octene, 1-nonene, 1-decene, 1-undecene, 1-dodecene, 1-tridecene, 1-tetradecene, 1-pentadecene, 1-hexadecene, 1-heptadecene, 1-octadecene, 1-nonadecene, and 1-eicosene; branched α-olefins such as 3-methyl-1-butene, 3-methyl-1-pentene, 4-methyl-1-pentene, 2-ethyl-1-hexene, and 2,2,4-trimethyl-1-pentene; and the like. Two kinds of these can be used in combination.

Among these, in view of versatility (costs, mass productivity, ease of availability), the number of carbon atoms in the α-olefin is preferably 3 to 10, and more preferably 3 to 8.

As the ethylene·α-olefin copolymer, an ethylene·propylene copolymer, an ethylene·1-butene copolymer, an ethylene·4-methyl-1-pentene copolymer, an ethylene·1-hexene copolymer, and an ethylene·1-octent copolymer are preferable. All of the ethylene·α-olefin copolymers mean a copolymer in which the proportion of the constitutional unit derived from ethylene contained in the copolymer is equal to or higher than 50 mol%.

The ethylene·α-olefin copolymer can be manufactured by, for example, a slurry polymerization method, a solution polymerization method, a bulk polymerization method, or a gas-phase polymerization method using a metallocene-based catalyst.

Examples of the ethylene·polar monomer copolymer include an ethylene·vinyl ester copolymer, an ethylene·unsaturated carboxylic acid ester copolymer, and the like. In the present embodiment, a polar monomer refers to a monomer having a functional group.

As the ethylene·vinyl ester copolymer, for example, it is possible to use one kind of copolymer or two or more kinds of copolymers selected from an ethylene·vinyl acetate copolymer, an ethylene·vinyl propionate copolymer, an ethylene·vinyl butyrate copolymer, an ethylene·vinyl stearate copolymer, and the like.

The ethylene·unsaturated carboxylic acid ester copolymer according to the present embodiment is a polymer obtained by copolymerizing ethylene with at least one kind of unsaturated carboxylic acid ester.

Specific examples of the aforementioned copolymer include a copolymer formed of ethylene and an alkyl ester of unsaturated carboxylic acid.

Examples of the unsaturated carboxylic acid in the unsaturated carboxylic acid ester include an acrylic acid, methacrylic acid, ethacrylic acid, crotonic acid, fumaric acid, maleic acid, maleic anhydride, itaconic acid, itaconic anhydride, and the like.

Examples of the alkyl moiety in the alkyl ester of unsaturated carboxylic acid include an alkyl group having 1 to 12 carbon atoms. More specific examples of the alkyl moiety include an alkyl group such as methyl, ethyl, n-propyl, isopropyl, n-butyl, isobutyl, sec-butyl, 2-ethylhexyl, or isooctyl. In the present embodiment, the number of carbon atoms in the alkyl moiety of the alkyl ester is preferably 1 to 8.

It is preferable that the copolymer contains, as the unsaturated carboxylic acid ester, one kind of ester or two or more kinds of esters selected from (meth)acrylic acid esters such as methyl (meth)acrylate, ethyl (meth)acrylate, isopropyl (meth)acrylate, n-propyl (meth)acrylate, isobutyl (meth)acrylate, n-butyl (meth)acrylate, isooctyl (meth)acrylate, and 2-etylhexyl (meth)acrylate. One kind of these unsaturated carboxylic acid esters may be used singly, or two or more kinds thereof may be used in combination. It is more preferable that the copolymer contains one kind of ester or two or more kinds of esters selected from methyl (meth)acrylate, ethyl (meth)acrylate, isopropyl (meth)acrylate, n-propyl (meth)acrylate, isobutyl (meth)acrylate, n-butyl (meth)acrylate, and the like among the above.

In the present embodiment, as the ethylene·unsaturated carboxylic acid ester copolymer, ethylene·(meth)acrylic acid ester copolymers are preferable. Among these, a copolymer containing one kind of compound as the (meth)acrylic acid ester is preferable. Examples of such a copolymer include an ethylene·methyl (meth)acrylate copolymer, an ethylene·ethyl (meth)acrylate copolymer, an ethylene·isopropyl (meth)acrylate copolymer, an ethylene·n-propyl (meth)acrylate copolymer, an ethylene·isobutyl (meth)acrylate copolymer, an ethylene·n-butyl (meth)acrylate copolymer, an ethylene·isooctyl (meth)acrylate copolymer, an ethylene·2-ethylhexyl (meth)acrylate copolymer, and the like.

The ethylene·polar monomer copolymer preferably contains one kind of copolymer or two or more kinds of copolymers selected from an ethylene·vinyl acetate copolymer, an ethylene·methyl (meth)acrylate copolymer, an ethylene·ethyl (meth)acrylate copolymer, an ethylene·isopropyl (meth)acrylate copolymer, an ethylene·n-propyl (meth)acrylate copolymer, an ethylene·isobutyl (meth)acrylate copolymer, and an ethylene·n-butyl (meth)acrylate copolymer, and more preferably contains an ethylene·vinyl acetate copolymer.

In the present embodiment, one kind of the ethylene·polar monomer copolymer may be used, or two or more kinds thereof may be used in combination.

Other resins described above may be modified with a silane coupling agent.

The content of the silane coupling agent is preferably 0.01% to 5% by weight with respect to 100% by weight of other resin components.

Furthermore, for example, various additives including an antioxidant such as hydroquinone monobenzyl ether or triphenyl phosphite, a heat stabilizer such as lead stearate or barium laurate, a light stabilizer, an antioxidant, a silane coupling agent, a filler such as titanium oxide particles or zinc oxide, a pigment, a dye, a lubricant, an anti-blocking agent, a foaming agent, a foaming aid, a cross-linking agent, a cross-linking aid, an ultraviolet absorber, a flame retardant, and an inorganic filler may be formulated with the resin material forming the resin sheet 10 according to the present embodiment. Particularly, in a case where the wiring sheet 100 is disposed on the back sheet side, the wiring sheet 100 is not required to have transparency. Therefore, from the viewpoint of improving power generation efficiency, it is preferable to formulate a pigment, a dye, and an inorganic filler with the resin material. As the aforementioned light stabilizer, for example, a hindered amine-based light stabilizer is used. The content of each component is preferably 0.005 to 2 parts by weight and more preferably 0.008 to 1 part by weight with respect to 100 parts by weight of the resin component in the resin sheet 10.

Specific examples of the hindered amine-based light stabilizer include 4-acetoxy-2,2,6,6-tetramethylpiperidine, 4-stearoyloxy-2,2,6,6-tetramethylpiperidine, 4-acryloyloxy-2,2,6,6-tetramethylpiperidine, 4-benzoyloxy-2,2,6,6-tetramethylpiperidine, 4-cyclohexanoyloxy-2,2,6,6-tetramethylpiperidine, 4-(o-chlorobenzoyloxy)-2,2,6,6-tetramethylpiperidine, 4-(phenoxyacetoxy)-2,2,6,6-tetramethylpiperidine, 1,3,8-triaza-7,7,9,9-tetramethyl-2,4-dioxo-3-n-octyl-spiro[4,5]decane, bis(2,2,6,6-tetramethyl-4-piperidyl)sebacate, bis(2,2,6,6-tetramethyl-4-piperidyl)terephthalate, bis(1,2,2,6,6-pentamethyl-4-piperidyl)sebacate, tris(2,2,6,6-tetramethyl-4-piperidyl)benzene-1,3,5-tricarboxylate, tris(2,2,6,6-tetramethyl-4-piperidyl)-2-acetoxypropane-1,2,3-tricarboxylate, tris(2,2,6,6-tetramethyl-4-piperidyl)-2-hydroxypropane-1,2,3-tricarboxylate, tris(2,2,6,6-tetramethyl-4-piperidyl)triazine-2,4,6-tricarboxylate, tris(2,2,6,6-tetramethyl-4-piperidine)phosphite, tris(2,2,6,6-tetramethyl-4-piperidyl)butane-1,2,3-tricarboxylate, tetrakis(2,2,6,6-tetramethyl-4-piperidyl)propane-1,1,2,3-tetracarboxylate, tetrakis(2,2,6,6-tetramethyl-4-piperidyl)butane-1,2,3,4-tetracarboxylate, and the like.

Examples of the antioxidant include various hindered phenol-based antioxidants and phosphite-based antioxidants. Specific examples of the hindered phenol-based antioxidants include 2,6-di-t-butyl-p-cresol, 2-t-butyl-4-methoxyphenol, 3-t-butyl-4-methoxyphenol, 2,6-di-t-butyl-4-ethylphenol, 2,2'-methylenebis(4-methyl-6-t-butylphenol), 2,2'-methylenebis(4-ethyl-6-t-butylphenol), 4,4'-methylenebis(2,6-di-t-butylphenol), 2,2'-methylenebis[6-(1-methylcyclohexyl)-p-cresol], bis[3,3-bis(4-hydroxy-3-t-butylphenyl)butyric acid]glycol ester, 4,4'-butylidenebis(6-t-butyl-m-cresol), 2,2'-ethylidenebis(4-sec-butyl-6-t-butylphenol), 2,2'-ethylidenebis(4,6-di-t-butylphenol), 1,1,3-tris(2-methyl-4-hydroxy-5-t-butylphenyl)butane, 1,3,5-tris(3,5-di-t-butyl-4-hydroxybenzyl)-2,4,6-trimethylbenzene, 2,6-diphenyl-4-ocatadecyloxyphenol, tetrakis[methylene-3-(3,5-di-t-butyl-4-hydroxyphenyl)propionate]methane, n-octadecyl-3-(3,5-dit-butyl-4-hydroxyphenyl)propionate, 4,4'-thiobis(6-t-butyl-m-cresol), tocopherol, 3,9-bis[1,1-dimethyl-2-[β-(3-t-butyl-4-hydroxy-5-methylphenyl)propionyloxy]ethyl]-2,4,8,10-tetraoxaspiro[5,5]undecane, 2,4,6-tris(3,5-di-t-butyl-4-hydroxybenzylthio)-1,3,5-triazine, pentaerythritol-tetrakis[3-(3,5-di-tert-butyl-4-hydroxyphenyl)propionate], and the like.

Specific examples of the phosphite-based antioxidants include 3,5-di-t-butyl-4-hydroxybenzylphosphanate dimethyl ester, ethyl 3,5-di-t-butyl-4-hydroxybenzyl phosphate, tris(2,4-di-t-butylphenyl)phosphanate, and the like.

Examples of the silane coupling agent include a silane coupling having a vinyl group, an amino group, or an epoxy group and a hydrolysable group such as an alkoxy group, a titanate coupling agent, and the like. Specific examples of the silane coupling agent include vinyl trimethoxysilane, γ-methacryloxypropyl trimethoxysilane, γ-methacryloxypropyl methyl dimethoxysilane, γ-acryloxypropyl trimethoxysilane, γ-glycidoxypropyl trimethoxysilane, 3-glycidoxypropyl methyl dimethoxysilane, 3-glycidoxypropyl methyl diethoxysilane, N-(2-aminoethyl)-3-aminopropyl trimethoxysilane, N-(2-aminoethyl)-3-aminopropyl methyl dimethoxysilane, N-(2-aminoethyl)-3-aminopropyl trimethoxysilane, 3-aminopropyl trimethoxysilane, 3-aminopropyl triethoxysilane, N-phenyl-3-aminopropyl trimethoxysilane, N-phenyl-3-aminopropyl triethoxysilane, and the like.

Examples of the ultraviolet absorber include benzophenone-based ultraviolet absorbers such as 2-hydroxy-4-methoxybenzophenone, 2,2'-dihydroxy-4-methoxybenzophenone, 2-hydroxy-4-methoxy-2-carboxybenzophenone, and 2-hydroxy-4-n-octoxybenzophenone; benzotriazole-based ultraviolet absorbers such as 2-(2'-hydroxy-3',5'-di-t-butylphenyl)benzotriazole, 2-(2'-hydroxy-5-methylphenyl)benzotriazole, 2-(2'-hydroxy-5-t-octylphenyl)benzotriazole, and 2-(2H-benzotriazol-2-yl)-4,6-di-tert-pentylphenol; and salicylic acid ester-based ultraviolet absorbers such as phenyl salicylate and p-octylphenyl salicylate.

Examples of the pigment include a white pigment such as titanium oxide or calcium carbonate, a blue pigment such as ultramarine, a black pigment such as carbon black, and the like. Particularly, from the viewpoint of preventing a decrease in insulation resistance of the photovoltaic generation module, it is preferable to formulate an inorganic pigment such as titanium oxide with the resin material.

For example, as an anti-tarnish agent, a fatty acid salt of a metal such as cadmium or barium may be arbitrarily formulated with the resin material forming the resin sheet 10 according to the present embodiment.

For the purpose of preventing positional deviation of the fine wires 20, it is preferable to apply an adhesive component onto a surface of the resin sheet 10 on which the fine wires 20 are disposed. Furthermore, the resin sheet 10 may form a multilayer structure. The total thickness of the resin sheet 10 is preferably equal to or greater than 10 $\mu$m and equal to or less than 500 $\mu$m, and more preferably equal to or greater than 25 $\mu$m and equal to or less than 200 $\mu$m.

In a case where the resin sheet 10 has a multilayer structure, the structure is preferably a three-layer structure. In this case, the film thickness of the surface layer (one surface) is preferably equal to or greater than 1 $\mu$m and equal to or less than 100 $\mu$m, and the film thickness of the interlayer is preferably equal to or greater than 4 $\mu$m and equal to or less than 400 $\mu$m.

<Method for manufacturing wiring sheet 100>

The method for manufacturing the wiring sheet 100 in the present embodiment is different from the manufacturing method of the related art. Therefore, it is necessary to highly control the composition of the formulation of the resin material forming the resin sheet 10 or the conditions relating to the method for bonding the resin sheet 10 to the fine wires 20. That is, by only the manufacturing method in which various factors relating to the following two conditions are highly controlled, it is possible to obtain the wiring sheet 100 in which the value of the light transmittance, measured based on JIS-K7105, of the resin sheet 10 at a wavelength of 350 nm satisfies the specific condition described above.

    (1) Selection of resin material forming resin sheet 10
    (2) Method for bonding resin sheet 10 to fine wires 20

Hereinafter, an example of the method for manufacturing the wiring sheet 100 according to the present embodiment will be described, but the method for manufacturing the wiring sheet 100 of the present embodiment is not limited to the following example. Furthermore, an example of the method for manufacturing the wiring sheet 100 of the present embodiment will be specifically described in examples.

(1) Selection of resin material forming resin sheet 10

As described above in the section of Solution to Problem, in order to obtain a resin material usable in the wiring sheet 100 which does not deteriorate even being irradiated with ultraviolet rays for a long period of time, various factors such as the type of the resin used, the density of the resin, the cross-linked state of the resin, and the type and amount of additives formulated with the resin need to be appropriately combined. Considering the point that the resin material needs to be hardly influenced by ultraviolet rays and excellent in mechanical properties such as strength, it is preferable that the resin material forming the resin sheet 10 according to the present embodiment contains any of the following (A) and (B) .

    (A) Copolymer containing ethylene and unsaturated carboxylic acid or ionomer of copolymer containing ethylene and unsaturated carboxylic acid
    (B) Copolymer containing ethylene and (meth)acrylic acid glycidyl

(2) Method for bonding resin sheet 10 to fine wires 20

In order to obtain the wiring sheet 100 according to the present embodiment, for example, a roll of the resin sheet 10 is bonded to wires forming the fine wires 20 by heating. At the time of manufacturing the wiring sheet 100 according to the present embodiment, the heating temperature of a pressed portion needs to be controlled such that only the surface of the resin sheet 10 is melted. Specifically, the heating temperature of the pressed portion is preferably controlled so as to become equal to or higher than 50°C and equal to or lower than 120°C. In a case where the heating temperature is controlled within the above range, it is possible to realize the wiring sheet 100 in which the positional deviation of the fine wires 20 is prevented. Furthermore, the resin sheet 10 and the fine wires 20 may be bonded by the method described in JP-A-2005-536894 for example.

<<Structure 200>>

Fig. 3 is an example of a cross-sectional view showing a structure 200 according to the present embodiment.

As shown in Fig. 3, the structure 200 according to the present embodiment includes the wiring sheet 100 and a sealing material 50 formed of a specific resin material. As the resin material forming the sealing material 50, any resin having a sealing capacity can be used without limitation. As the resin material, a resin material containing any of the following (A) and (B) is preferable. In a case where the structure 200 is disposed on the rear side of a cell, from the viewpoint of improving power generation efficiency, it is preferable to formulate a white pigment with the resin material forming the sealing material 50. The resin material forming the sealing material 50 and the resin material forming the resin sheet 10 described above may be the same or may have different formulations.

(A) Copolymer containing ethylene and unsaturated carboxylic acid or ionomer of copolymer containing ethylene and unsaturated carboxylic acid
(B) Copolymer containing ethylene and (meth)acrylic acid glycidyl

Next, the resin material forming the sealing material 50 according to the present embodiment will be described.

As described above, the sealing material 50 according to the present embodiment is preferably formed of a resin material containing any of the following (A) and (B).

(A) Copolymer containing ethylene and unsaturated carboxylic acid or ionomer of copolymer containing ethylene and unsaturated carboxylic acid
(B) Copolymer containing ethylene and (meth)acrylic acid glycidyl

Examples of the unsaturated carboxylic acid component in the copolymer of ethylene and unsaturated carboxylic acid or the ionomer of the copolymer of ethylene and unsaturated carboxylic acid contained in the sealing material 50 according to the present embodiment include acrylic acid, methacrylic acid, ethacrylic acid, fumaric acid, maleic acid, monomethyl maleate, maleic anhydride, and the like. Among these, (meth)acrylic acid is preferable as the unsaturated carboxylic acid component. Therefore, as the copolymer of ethylene and unsaturated carboxylic acid, an ethylene·(meth)acrylic acid copolymer is preferable. The ethylene·unsaturated carboxylic acid copolymer according to the present embodiment is not limited to the binary copolymer of ethylene and unsaturated carboxylic acid, and includes a multi-component copolymer containing ethylene and unsaturated carboxylic acid, such as an ethylene·unsaturated carboxylic acid·unsaturated carboxylic acid ester copolymer. Examples of the unsaturated carboxylic acid ester component in the ethylene·unsaturated carboxylic acid·unsaturated carboxylic acid ester copolymer include alkyl esters, having 1 to 20 carbon atoms, of various carboxylic acids used as the unsaturated carboxylic acid component. Specifically, examples of the alkyl group include a methyl group, an ethyl group, an n-propyl group, an isopropyl group, an n-butyl group, an isobutyl group, a 2-ethylhexyl group, an isooctyl group, and the like.

From the viewpoint of realizing excellent ultraviolet ray-transmitting properties, the content of an unsaturated carboxylic acid unit such as a (meth)acrylic acid unit in the copolymer of ethylene and unsaturated carboxylic acid or an ionomer thereof contained in the sealing material 50 according to the present embodiment is preferably equal to or greater than 2% by weight and equal to or less than 30% by weight, more preferably equal to or greater than 4% by weight and equal to or less than 25% by weight, even more preferably equal to or greater than 9% by weight and equal to or less than 25% by weight, and most preferably equal to or greater than 12% by weight and equal to or less than 20% by weight.

In a case where the copolymer contains an unsaturated carboxylic acid ester, the content of the unsaturated carboxylic acid ester is, with respect to the total amount of the copolymer, preferably equal to or greater than 1% by weight and equal to or less than 35% by weight, more preferably equal to or greater than 3% by weight and equal to or less than 32% by weight, and even more preferably equal to or greater than 5% by weight and equal to or less than 30% by weight.

A metal species derived from an alkali metal such as lithium or sodium, a polyvalent metal such as calcium, magnesium, cerium, zinc, or aluminum, or the like can be incorporated into the ionomer of the copolymer of ethylene and unsaturated carboxylic acid contained in the sealing material 50 according to the present embodiment. Among these, sodium, magnesium, and zinc are preferably used. Generally, an ionomer is known to have excellent transparency and have a high storage modulus E' at a high temperature. A degree of neutralization of the ionomer of the copolymer of ethylene and unsaturated carboxylic acid contained in the sealing material 50 according to the present embodiment is preferably equal to or lower than 80%, more preferably equal to or lower than 60% from the viewpoint of adhesiveness, and most preferably equal to or lower than 40%.

In a case where the sealing material 50 according to the present embodiment is formed of the copolymer of ethylene and unsaturated carboxylic acid or the ionomer of the copolymer of ethylene and unsaturated carboxylic acid, from the viewpoint of causing the copolymer to exhibit excellent transparency and adhesiveness, the content of the unsaturated carboxylic acid with respect to the total amount of the copolymer is preferably equal to or greater than 1% by weight, more preferably equal to or greater than 2% by weight, and even more preferably equal to or greater than 3% by weight. In contrast, from the viewpoint of reducing hygroscopicity, the content of the unsaturated carboxylic acid with respect to the total amount of the copolymer is preferably equal to or less than 20% by weight, and more preferably equal to or less than 15% by weight.

In a case where the copolymer contains an unsaturated carboxylic acid ester, from the viewpoint of causing the copolymer to exhibit excellent transparency and adhesiveness, the content of the unsaturated carboxylic acid ester with respect to the total amount of the copolymer is preferably equal to or greater than 1% by weight, more preferably equal to or greater than 3% by weight, and even more preferably equal to or greater than 5% by weight. In contrast, in a case where the copolymer contains an unsaturated carboxylic acid ester, from the viewpoint of reducing hygroscopicity, the content of the unsaturated carboxylic acid ester with respect to the total amount of the copolymer is preferably equal to or less than 35% by weight, and more preferably equal to or less than 30% by weight.

The melting point of the copolymer of ethylene and unsaturated carboxylic acid contained in the sealing material 50 according to the present embodiment is preferably equal to or higher than 55°C, more preferably equal to or higher than 60°C, and most preferably equal to or higher than 70°C. In a case where the melting point is as described above, it is possible to inhibit the deformation of the resin sheet 10 in a case where the temperature increases at the time of using the photovoltaic generation module, and to inhibit the leakage of the resin material or the occurrence of burr at the time of manufacturing the photovoltaic generation module.

The copolymer of ethylene and unsaturated carboxylic acid contained in the sealing material 50 according to the present embodiment can be obtained by performing a radical copolymerization reaction under the conditions of a high temperature and a high pressure. Furthermore, the ionomer of the copolymer of ethylene and unsaturated carboxylic acid can be obtained by reacting the copolymer of ethylene and unsaturated carboxylic acid with a metal compound.

The (meth)acrylic acid glycidyl contained in the copolymer containing ethylene and (meth)acrylic acid glycidyl contained in the sealing material 50 according to the present embodiment refers to at least one of methacrylic acid glycidyl and acrylic acid glycidyl.

Examples of the copolymer containing ethylene and (meth)acrylic acid glycidyl include one kind of copolymer or two or more kinds of copolymers selected from an ethylene·(meth) acrylic acid glycidyl copolymer, an ethylene·(meth) acrylic acid glycidyl·vinyl acetate copolymer, and an ethylene·(meth) acrylic acid glycidyl·(meth)acrylic acid ester copolymer, and the like.

The proportion of a constitutional unit derived from (meth)acrylic acid glycidyl contained in the copolymer containing ethylene and (meth)acrylic acid glycidyl is preferably equal to or higher than 2% by weight and equal to or lower than 30% by weight, and more preferably equal to or higher than 3% by weight and equal to or lower than 25% by weight.

In a case where the proportion of the constitutional unit derived from (meth)acrylic acid glycidyl contained in the copolymer is within the above range, the adhesiveness, the flexibility, the handleability, the workability, and the like of the obtained sealing material 50 are balanced much better.

The proportion of the "constitutional unit derived from ethylene" contained in the copolymer containing ethylene and (meth)acrylic acid glycidyl is preferably equal to or higher than 65% by weight, more preferably equal to or higher than 70% by weight, and particularly preferably equal to or higher than 80% by weight. At this time, the copolymer containing ethylene and (meth)acrylic acid glycidyl may additionally contain monomer units (for example, vinyl acetate, a (meth)acrylic acid ester, and the like) other than ethylene and (meth)acrylic acid glycidyl.

Specifically, example of the aforementioned copolymer include a copolymer containing a constitutional unit derived from ethylene and a constitutional unit derived from a (meth)acrylic acid glycidyl, a copolymer containing the aforementioned two constitutional units and at least one of the constitutional unit derived from vinyl acetate and the constitutional unit derived from (meth)acrylic acid ester, and the like.

The proportion of the constitutional unit derived from vinyl acetate and the constitutional unit derived form (meth)acrylic acid ester contained in the copolymer is preferably equal to or lower than 30% by weight, and more preferably equal to or lower than 20% by weight.

The lower limit of the proportion of the constitutional unit derived from vinyl acetate and the constitutional unit derived from (meth)acrylic acid ester contained in the copolymer is not particularly limited, but is preferably equal to or higher than 0.1% by weight, more preferably equal to or higher than 0.5% by weight, and even more preferably equal to or higher than 1% by weight. The proportion of the constitutional unit derived from vinyl acetate or the constitutional unit derived from a (meth)acrylic acid ester contained in the copolymer is preferably within a range of 0.1% to 30% by weight, more preferably within a range of 0.5% to 20% by weight, and particularly preferably within a range of 1% to 20% by weight.

One kind of the copolymer containing ethylene and (meth)acrylic acid glycidyl can be used singly. Alternatively, two or more kinds of the copolymer having different copolymerization ratios or two or more kinds of the copolymer containing different monomer species can be used in combination.

At least a portion of the copolymer containing ethylene and (meth)acrylic acid glycidyl may be modified with a silane coupling agent.

The content of the silane coupling agent is preferably 0.01% to 5% by weight with respect to 100% by weight of the copolymer containing ethylene and (meth)acrylic acid glycidyl.

The sealing material 50 may contain any of (A) and (B) described above. It is preferable that the total content of (A) and (B) with respect to 100% by weight of the resin component in the sealing material 50 is preferably equal to or greater than 30% by weight, more preferably equal to or greater than 40% by weight, and even more preferably equal to or greater than 50% by weight. The upper limit of the content is not particularly limited, but in a case where the sealing material 50 contains (B), the upper limit is preferably equal to or less than 80% by weight, and more preferably equal to or less than 60% by weight.

The resin material forming the sealing material 50 according to the present embodiment may contain other resins. Examples of other resins include a propylene-based resin, an ethylene-based resin, and the like.

Examples of the ethylene-based resin include an ethylene·α-olefin copolymer, an ethylene·polar monomer copolymer, and the like in which the proportion of a constitutional unit derived from an α-olefin having 3 to 20 carbon atoms contained in the copolymer is equal to or higher than 5 mol% and less than 50 mol%.

Specific examples of the α-olefin having 3 to 20 carbon atoms include linear α-olefins such as propylene, 1-butene, 1-pentene, 1-hexene, 1-heptene, 1-octene, 1-nonene, 1-decene, 1-undecene, 1-dodecene, 1-tridecene, 1-tetradecene, 1-pentadecene, 1-hexadecene, 1-heptadecene, 1-octadecene, 1-nonadecene, and 1-eicosene; branched α-olefins such as 3-methyl-1-butene, 3-methyl-1-pentene, 4-methyl-1-pentene, 2-ethyl-1-hexene, and 2,2,4-trimethyl-1-pentene; and the like. Two kinds of these can be used in combination.

Among these, in view of versatility (costs, mass productivity, or ease of availability), the number of carbon atoms in the α-olefin is preferably 3 to 10, and more preferably 3 to 8.

As the ethylene·α-olefin copolymer, an ethylene·propylene copolymer, an ethylene·1-butenen copolymer, an ethylene·4-methyl-1-pentene copolymer, an ethylene·1-hexene copolymer, and an ethylene·1-ocetne copolymer are preferable. All of the ethylene·α-olefin copolymers mean a copolymer in which the proportion of the constitution derived from ethylene contained in the copolymer is equal to or higher than 50 mol%.

The ethylene·α-olefin copolymer can be manufactured by, for example, a slurry polymerization method, a solution polymerization method, a bulk polymerization method, a gas-phase polymerization method, and the like using a metallocene catalyst.

Examples of the ethylene·polar monomer copolymer include an ethylene·vinyl ester copolymer, an ethylene·unsaturated carboxylic acid ester copolymer, and the like. In the present embodiment, the polar monomer refers to a monomer having a functional group.

As the ethylene·vinyl ester copolymer, for example, it is possible to use one kind of copolymer or two or more kinds of copolymers selected from an ethylene·vinyl acetate copolymer, an ethylene·vinyl propionate copolymer, an ethylene·vinyl butyrate copolymer, an ethylene·vinyl stearate copolymer, and the like.

The ethylene·unsaturated carboxylic acid ester copolymer according to the present embodiment is a polymer obtained by copolymerizing ethylene with at least one kind of unsaturated carboxylic acid ester.

Specifically, examples of the aforementioned copolymer include a copolymer formed of ethylene and an alkyl ester of unsaturated carboxylic acid.

Examples of the unsaturated carboxylic acid in the unsaturated carboxylic acid ester include acrylic acid, methacrylic acid, ethacrylic acid, crotonic acid, fumaric acid, maleic acid, maleic anhydride, itaconic acid, itaconic anhydride, and the like.

Examples of the alkyl moiety in the alkyl ester of unsaturated carboxylic acid include an alkyl group having 1 to 12 carbon atoms. More specific examples of the alkyl moiety include an alkyl group such as methyl, ethyl, n-propyl, isopropyl, n-butyl, isobutyl, sec-butyl, 2-ethylhexyl, or isooctyl. In the present embodiment, the number of carbon atoms in the alkyl moiety of the alkyl ester is preferably 1 to 8.

It is preferable that the copolymer contains, as the unsaturated carboxylic acid ester, one kind of ester or two or more kinds of esters selected from (meth)acrylic acid esters such as methyl (meth)acrylate, ethyl (meth)acrylate, isopropyl (meth)acrylate, n-propyl (meth)acrylate, isobutyl (meth)acrylate, n-butyl (meth)acrylate, isooctyl (meth)acrylate, and 2-etylhexyl (meth)acrylate. One kind of these unsaturated carboxylic acid esters may be used singly, or two or more kinds thereof may be used in combination. It is more preferable that the copolymer contains one kind of ester or two or more kinds of esters selected from methyl (meth)acrylate, ethyl (meth)acrylate, isopropyl (meth)acrylate, n-propyl (meth)acrylate, isobutyl (meth)acrylate, n-butyl (meth)acrylate, and the like among the above.

In the present embodiment, as the ethylene·unsaturated carboxylic acid ester copolymer, ethylene·(meth)acrylic acid ester copolymers are preferable. Among these, a copolymer containing one kind of compound as the (meth)acrylic acid ester is preferable. Examples of such a copolymer include an ethylene·methyl (meth)acrylate copolymer, an ethylene·ethyl (meth)acrylate copolymer, an ethylene·isopropyl (meth)acrylate copolymer, an ethylene·n-propyl (meth)acrylate copolymer, an ethylene·isobutyl (meth)acrylate copolymer, an ethylene·n-butyl (meth)acrylate copolymer, an ethylene·isooctyl (meth)acrylate copolymer, an ethylene·2-ethylhexyl (meth)acrylate copolymer, and the like.

The ethylene·polar monomer copolymer preferably contains one kind of copolymer or two or more kinds of copolymers selected from an ethylene·vinyl acetate copolymer, an ethylene·methyl (meth) acrylate copolymer, an ethylene·ethyl (meth)acrylate copolymer, an ethylene·isopropyl (meth) acrylate copolymer, an ethylene·n-propyl (meth)acrylate copolymer, an ethylene·isobutyl (meth)acrylate copolymer, and an ethylene·n-butyl (meth)acrylate copolymer, and more preferably contains an ethylene·vinyl acetate copolymer.

In the present embodiment, one kind of the ethylene·polar monomer copolymer may be used, or two or more kinds thereof may be used in combination.

Other resins described above may be modified with a silane coupling agent.

The content of the silane coupling agent is preferably 0.01% to 5% by weight with respect to 100% by weight of other resin components.

Furthermore, for example, various additives including an antioxidant such as hydroquinone monobenzyl ether or triphenyl phosphite, a heat stabilizer such as lead stearate or barium laurate, a filler such as titanium oxide particles or zinc oxide, a pigment, a dye, a lubricant, an anti-blocking agent, a foaming agent, a foaming aid, a cross-linking agent, a cross-linking aid, an ultraviolet absorber, a flame retardant, and an inorganic filler may be formulated with the resin material forming the sealing material 50 according to the present embodiment. The content of each component is preferably 0.005 to 2 parts by weight and more preferably 0.008 to 1 part by weight with respect to 100 parts by weight of the resin component in the sealing material 50.

Particularly, the sealing material 50 used on the back sheet side is not required to have transparency. Therefore, from the viewpoint of improving power generation efficiency, it is preferable to formulate a pigment, a dye, and an inorganic filler with the resin material. Examples of the pigment include a white pigment such as titanium oxide or calcium carbonate, a blue pigment such as ultramarine, a black pigment such as carbon black, and the like. Especially, from the viewpoint of preventing a decrease in insulation resistance of the photovoltaic generation module, it is preferable to formulate an inorganic pigment such as titanium oxide with the resin material. The amount of the inorganic pigment formulated with the resin material is, with respect to 100 parts by weight of the resin component contained in the sealing material 50, preferably equal to or greater than 0 part by weight and equal to or less than 100 parts by weight, more preferably equal to or greater than 0.5 parts by weight and equal to or less than 50 parts by weight, and most preferably equal to or greater than 4 parts by weight and equal to or less than 50 parts by weight.

For example, as an anti-tarnish agent, a fatty acid salt of a metal such as cadmium or barium may be arbitrarily formulated with the resin material forming the sealing material 50 according to the present embodiment. In a case where the sealing material 50 has a multilayer structure, at least one layer is formed of the various resins described above, and all of the layers may be constituted with the various resins described above.

The film thickness of the sealing material 50 is preferably equal to or greater than 50 $\mu$m and equal to or less than 1,000 $\mu$m, and more preferably equal to or greater than 100 $\mu$m and equal to or less than 500 $\mu$m. In addition, the light transmittance of the sealing material 50, which is disposed on a light-receiving surface (light incidence surface) of the photovoltaic generation module, measured based on JIS-K7105 at a wavelength of 350 nm is preferably equal to or higher than 70%. If the light transmittance is as described above, it is possible to realize a module which enables the light energy derived from ultraviolet rays to efficiently contribute to power generation.

In a case where the sealing material 50 has a multilayer structure, the structure is preferably a three-layer structure. In this case, the film thickness of the surface layer (one surface) is preferably equal to or greater than 10 $\mu$m and equal to or less than 500 $\mu$m, and the film thickness of the interlayer is preferably equal to or greater than 50 $\mu$m and equal to or less than 1,000 $\mu$m.

<<Photovoltaic generation module 300-1>>

Fig. 4 is an example of a cross-sectional view showing a photovoltaic generation module 300-1 according to the present embodiment.

As shown in Fig. 4, the photovoltaic generation module 300-1 according to the present embodiment includes a light-transmitting substrate 70, the wiring sheet 100, and the sealing material 50. As described above, the photovoltaic generation module 300-1 includes the wiring sheet 100 in which the light transmittance of the resin sheet 10 in a region of a wavelength of 350 nm is equal to or higher than 70%. Accordingly, the photovoltaic generation module 300-1 enables the light energy derived from ultraviolet rays to efficiently contribute to power generation. Therefore, the photovoltaic generation module 300-1 according to the present embodiment have better power generation efficiency compared to a photovoltaic generation module of the related art.

Examples of the light-transmitting substrate 70 include glass, an acrylic resin, polycarbonate, polyester, a fluorine-containing resin, and the like. Among these, from the viewpoint of causing more light energy to contribute to power generation, glass is preferable.

Examples of the photovoltaic generation element 400 in the photovoltaic generation module 300-1 according to the present embodiment include a silicon-based element such as monocrystalline silicon, polycrystalline silicon, amorphous silicon, a heterojunction-type element, a group III compound-group V compound semiconductor-based element such as gallium-arsenide, copper-indium-selenide, or cadmium-telluride, and group II compound semiconductor compound-group VI compound semiconductor-based element.

Examples of a back sheet 80 used in the photovoltaic generation module 300-1 according to the present embodiment include a single layer sheet or a multilayer sheet formed of a metal such as tin, aluminum, or stainless steel, an inorganic material such as glass, or a thermoplastic resin such as polyester, inorganic vapor-deposited polyester, a fluorine-containing resin, or a polyolefin. Among these, from the viewpoint of reducing the manufacture cost of the photovoltaic generation module 300-1 by skipping an insulation treatment in the manufacturing process, it is preferable to use the material other than aluminum to form the back sheet 80.

For the photovoltaic generation module according to the present embodiment, any aspect may be adopted as long as the module enables the light energy derived from ultraviolet rays to efficiently contribute to power generation.

Specifically, for example, the photovoltaic generation module according to the present embodiment is constituted with the light-transmitting substrate 70/wiring sheet 100/photovoltaic generation element 400/wiring sheet 100/back sheet 80 (protective material) such that both surfaces of the photovoltaic generation element 400 are sealed as if being interposed between two wiring sheets 100; constituted with light-transmitting substrate 70/sealing material 50/wiring sheet 100/photovoltaic generation element 400/wiring sheet 100/sealing material 50/back sheet 80 (protective material) such that both surfaces of the photovoltaic generation element 400 are sealed as if being interposed between two wiring sheets 100, and that the sealing material 50 is interposed between the light-transmitting substrate 70 and the wiring sheet 100; constituted with light-transmitting substrate 70/photovoltaic generation element 400/wiring sheet 100/back sheet 80 (protective material) by using the photovoltaic generation element 400 formed in advance on the surface of the light-transmitting substrate 70; or constituted with the amorphous photovoltaic generation element 400, which is prepared on a fluorine resin-based sheet on the light-transmitting substrate 70 by sputtering or the like, and the wiring sheet 100 and the back sheet 80 (protective material) which are formed on the photovoltaic generation element 400.

Examples of other types of photovoltaic generation modules include a photovoltaic generation module constituted with the photovoltaic generation element 400 formed on the back sheet 80 (protective material) and the wiring sheet 100 and the light-transmitting substrate 70 which are formed on the photovoltaic generation element 400, and a photovoltaic generation module constituted with the photovoltaic generation element 400 formed on the light-transmitting substrate 70 and the wiring sheet 100 and the back sheet 80 (protective material) which are formed on the photovoltaic generation element 400. Specifically, examples of the photovoltaic generation module include a module constituted with the amorphous photovoltaic generation element 400 prepared on glass by sputtering or the like and the wiring sheet 100 and the back sheet 80 which are formed on the photovoltaic generation element 400.

(Second embodiment)

<<Wiring sheet 100>>

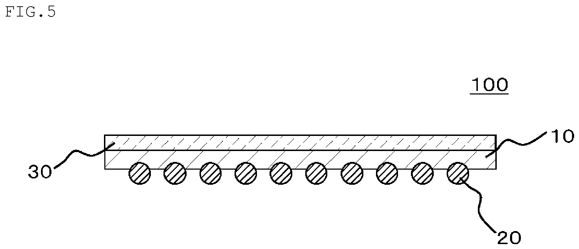

Fig. 5 is an example of a cross-sectional view showing the wiring sheet 100 according to the present embodiment.

The wiring sheet 100 shown in Fig. 5 is different from the first embodiment, in the respect that a base material layer 30 is laminated on a surface of the resin sheet 10 opposite to the surface to which the fine wires 20 are bonded. Specifically, the wiring sheet 100 shown in Fig. 5 has the base material layer 30 formed of a material containing one or more resins selected from the group consisting of a fluorine resin and an acrylic resin, on a surface of the resin sheet 10 opposite to the surface provided with the fine wires 20. Herein, the Shore D hardness of the material forming the base material layer 30 that is measured under the condition of room temperature based on JIS-K7125 by using a type D durometer is preferably equal to or higher than 10 and equal to or lower than 100, and more preferably equal to or higher than 20 and equal to or lower than 100. In a case where the Shore D hardness of the material forming the base material layer 30 is within the aforementioned range of numerical values, the fine wires 20 can be appropriately buried in the resin sheet 10, and hence the power generation efficiency can be further improved. The thickness of the base material 30 is preferably equal to or greater than 5 $\mu$m equal to or less than equal to or less than 100 $\mu$m, and more preferably equal to or greater than 10 $\mu$m equal to or less than 80 $\mu$m. In addition, the light transmittance of the base material layer 30, which is disposed on the light-receiving surface (light incidence surface) of the photovoltaic generation module, measured based on JIS-K7105 at a wavelength of 350 nm is preferably equal to or higher than 70%. In a case where the light transmittance is as described above, it is possible to realize a module which enables the light energy derived from ultraviolet rays to efficiently contribute to power generation.

Examples of the aforementioned fluorine resin include a tetrafluoroethylene·ethylene copolymer (ETFE), a tetrafluoroethylene·hexafluoropropylene copolymer (FEP), a tetrafluoroethylene·perfluoroalkyl vinyl ether copolymer (PFA), polychlorotrifluoroethylene (PCTFE), a chlorotrifluoroethylene·ethylene copolymer (PCTFEE), polyvinyl fluoride (PVF), polyvinylidene fluoride (PVDF), and the like. Among these, one or more kinds of resins selected from the group consisting of a tetrafluoroethylene·ethylene copolymer (ETFE), a tetrafluoroethylene·hexafluoropropylene copolymer (FEP), and polyvinyl fluoride (PVF) are preferable.

Examples of the aforementioned acrylic resin include a polymer of an acrylic acid ester, a polymer of a methacrylic acid ester, and the like. Among these, a methacrylic resin is preferable which is a polymer containing a methyl methacrylate unit as a main component. Examples of the methacrylic resin include polymethyl methacrylate (PMMA), a copolymer of methyl methacrylate and other monomers, and the like.

In order to cause the fluorine resin or the acrylic resin to more reliably come into close contact with the sealing material 50, the surface of the fluorine resin or the acrylic resin may be subjected to a surface treatment such as a corona discharge treatment, a plasma discharge treatment, or a flame treatment, or an adhesive may be used. As the adhesive, those having excellent water resistance are preferable, and examples thereof include an olefin-based polymer modified with silane or maleic anhydride, a urethane-based resin, a silicone-based resin, and the like.

<<Photovoltaic generation module 300-2>>

A photovoltaic generation module 300-2 according to the present embodiment is different from the first embodiment, in the respect that the wiring sheet 100 having the aforementioned base material 30 is used in the module. Specifically, for example, the photovoltaic generation module 300-2 according to the present embodiment adopts an aspect in which the module includes the heterojunction-type photovoltaic generation element 400 described below. However, the photovoltaic generation module 300-2 according to the present embodiment is not limited to the module including the heterojunction-type photovoltaic generation element 400 described below.

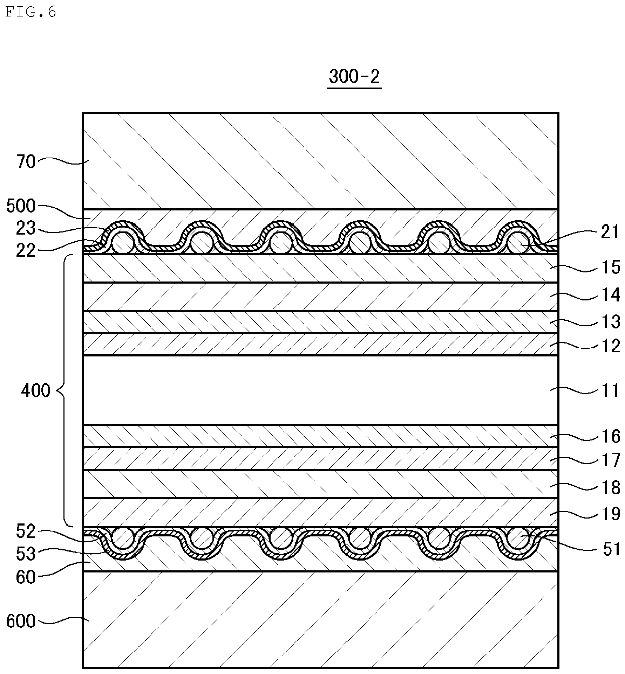

Fig. 6 is an example of a schematic cross-sectional view showing the layered structure of the photovoltaic generation module 300-2 according to the present embodiment.

As shown in Fig. 6, the photovoltaic generation module 300-2 according to the present embodiment includes the heterojunction-type photovoltaic generation element 400.

The photovoltaic generation element 400 includes a first conductivity-type crystal semiconductor substrate 11 as well as a first amorphous semiconductor film 12, a first conductivity-type second amorphous semiconductor film 13, a first light-transmitting electrode film 14, and a first electrode 15 in this order on one surface side of the crystal semiconductor substrate 11.

Furthermore, the photovoltaic generation element 400 has a third intrinsic amorphous semiconductor film 16, a second conductivity-type fourth amorphous semiconductor film 17, a second light-transmitting electrode film 18, and a second electrode 19 in this order on the other surface side of the crystal semiconductor substrate 11.

The first amorphous semiconductor film 12 is a first conductivity-type semiconductor film in which the concentration of impurities is lower than in the second amorphous semiconductor film 13, or an intrinsic semiconductor film.

Furthermore, the photovoltaic generation module 300-2 includes a plurality of first fine wires 21 bonded and fixed to the first electrode 15 on one surface of the photovoltaic generation element 400 by a first resin sheet 22, a first base material layer 23, which is provided for making the plurality of fine wires 21 interposed between the first base material layer 23 and one surface of the photovoltaic generation element 400 and is bonded to one surface of the photovoltaic generation element 400 through the first resin sheet 22, the light-transmitting substrate 70, and a first sealing layer 500 with which the space between the light-transmitting substrate 70 and the first substrate layer 23 is filled.

The photovoltaic generation module 300-2 also includes a plurality of second fine wires 51 bonded and fixed to the second electrode 19 on the other surface of the photovoltaic generation element 400 by a second resin sheet 52, a second base material layer 53, which is provided to make the plurality of second fine wires 51 interposed between the second base material layer 53 and the other surface of the photovoltaic generation element 400 and is bonded to the other surface of the photovoltaic generation element 400 through the second resin sheet 52, a second protective layer 600, and a second sealing layer 60 with which the space between the second protective layer 600 and the second base material layer 53 is filled.

Regarding the conductivity type of each constituent of the photovoltaic generation element 400, specifically, the crystal semiconductor substrate 11 is an n-type for example. In this case, the second amorphous semiconductor film 13 is an n-type, the first amorphous semiconductor film 12 is an intrinsic or n-type (n-type in which the concentration of impurities is lower than in the second amorphous semiconductor film 13), and the fourth amorphous semiconductor film 17 is a p-type.

The crystal semiconductor substrate 11 is not particularly limited as long as the substrate is a crystal having characteristics of an n-type semiconductor, and known crystal semiconductor substrates can be used. Examples of the n-type crystal semiconductor constituting the crystal semiconductor substrate 11 include silicon (Si), SiC, SiGe, SiN, and the like. In view of productivity and the like, silicon is preferable. The crystal semiconductor substrate 11 may be a monocrystal or a polycrystal.

Each of the first amorphous semiconductor film 12, the second amorphous semiconductor film 13, the third amorphous semiconductor film 16, and the fourth amorphous semiconductor film 17 can be a silicon thin film.

The first amorphous semiconductor film 12 is laminated on one surface (upper surface in Fig. 6) of the crystal semiconductor substrate 11.

The second amorphous semiconductor film 13 is laminated on one surface (upper surface in Fig. 6) of the first amorphous semiconductor film 12.

The total film thickness of the first amorphous semiconductor film 12 and the second amorphous semiconductor film 13 can be equal to or greater than 1 nm and equal to or less than 20 nm for example.

The first light-transmitting electrode film 14 is laminated on one surface (upper surface in Fig. 6) of the second amorphous semiconductor film 13.

Specific examples of the transparent electrode material constituting the first light-transmitting electrode film 14 include known materials such as indium tin oxide (ITO), indium tungsten oxide (IWO), indium cerium oxide (ICO), indium zinc oxide (IZO), aluminum-doped ZnO (AZO), and gallium-doped ZnO (GZO).

The third amorphous semiconductor film 16 is laminated on the other surface (lower surface in Fig. 6) of the crystal semiconductor substrate 11. The fourth amorphous semiconductor film 17 is laminated on the other surface (lower surface in Fig. 6) of the third amorphous semiconductor film 16. In other words, the third amorphous semiconductor film 16 is between the crystal semiconductor substrate 11 and the fourth amorphous semiconductor film 17. The film thickness of the third amorphous semiconductor film 16 can be equal to or greater than 1 nm and equal to or less than 10 nm for example. The film thickness of the fourth amorphous semiconductor film 17 can be equal to or greater than 1 nm and equal to or less than 20 nm for example.

The second light-transmitting electrode film 18 is laminated on one surface (lower surface in Fig. 6) of the fourth amorphous semiconductor film 17. The material constituting the second light-transmitting electrode film 18 is the same as the material constituting the first light-transmitting electrode film 14.

Herein, "intrinsic" means that the semiconductor is intentionally doped with impurities. Accordingly, the intrinsic amorphous semiconductor film includes semiconductor films in which the impurities intrinsic to the raw material or the impurities unintentionally intermixed in the manufacturing process exist.

Furthermore, "amorphous" means that the semiconductor contains not only an amorphous substance but also a fine crystal.

The n-type amorphous semiconductor film refers to a semiconductor film containing impurities, expressed as a ratio of number density of the elements contained in the thin film, at about equal to or higher than $10^{-5}$ with respect to silicon.

The first electrode 15 is, for example, a finger electrode or a metal film formed on the entirety of the other surface (upper surface in Fig. 6) of the first light-transmitting electrode film 14.

Likewise, the second electrode 19 is a finger electrode or a metal film formed on the entirety of the other surface (lower surface in Fig. 6) of the second light-transmitting electrode film 18.

As the material of the finger electrode constituting the first electrode 15 and the second electrode 19, a conductive adhesive such as silver paste or metal conductive wires such as copper wires can be used. The width of the finger electrode is about equal to or greater than 20 $\mu$m and equal to or less than 80 $\mu$m for example.

As the metal film constituting the first electrode 15 and the second electrode 19, a conductive adhesive such as silver paste can be used. The plurality of first fine wires 21 are, for example, a plurality of wires or busbars disposed in parallel with each other.

The photovoltaic generation module according to the present embodiment can be prepared by the following method for example. For describing an example of the method for manufacturing the photovoltaic generation module, the aforementioned photovoltaic generation module 300-2 shown in Fig. 6 will be used for example.

First, on one surface of the crystal semiconductor substrate 11, the first amorphous semiconductor film 12, the second amorphous semiconductor film 13, and the first light-transmitting electrode film 14 are formed in this order. Meanwhile, on the other surface of the crystal semiconductor substrate 11, the third amorphous semiconductor film 16, the fourth amorphous semiconductor film 17, and the second light-transmitting electrode film 18 are formed in this order. Furthermore, the first electrode 15 is formed on one surface (upper surface in Fig. 6) of the first light-transmitting electrode film 14, and the second electrode 19 is formed on the other surface (lower surface in Fig. 6) of the second light-transmitting electrode film 18. In this way, the photovoltaic generation element 400 is obtained.

Then, the first base material layer 23, a first multi-wire member in which the first resin sheet 22 and the first fine wires 21 are integrated, the light-transmitting substrate 70, and a sheet-like first sealing layer 500 are prepared.

Thereafter, the first multi-wire member is interposed between the first electrode 15 and the light-transmitting substrate 70 on one surface of the photovoltaic generation element 400, and the first sealing layer 500 is interposed between the first multi-wire member and the light-transmitting substrate 70.

Likewise, the second base material layer 53, a second multi-wire member in which the second resin sheet 52 and the second fine wires 51 are integrated, the second protective layer 600, and a sheet-like second sealing layer 60 are prepared.

Then, the second multi-wire member is disposed between the second electrode 19 and the second protective layer 600 on the other surface of the photovoltaic generation element 400, and the second sealing layer 60 is disposed between the second multi-wire member and the second protective layer 600.

Subsequently, all of the above members are collectively heated and pressed from both surfaces such that the first fine wires 21 are welded to the first electrode 15 through the first resin sheet 22, the first base material layer 23 is welded to the light-transmitting substrate 70 through the first sealing layer 500, the second fine wires 51 are welded to the second electrode 19 through the second resin sheet 52, and the second base material layer 53 is welded to the second protective layer 600 through the second sealing layer 60. In this way, the photovoltaic generation module 300-2 can be obtained.

The present invention is not limited to the embodiments described above, and as long as the object of the present invention can be achieved, the present invention can be modified or ameliorated.

Hitherto, the embodiments of the present invention have been described with reference to drawings. However, the embodiments are merely examples of the present invention, and various constitutions other than the above can be adopted.

[Examples]

Hereinafter, the present invention will be described based on examples and comparative examples, but the present invention is not limited thereto.

The raw materials used in examples and comparative examples will be shown below.

<Raw material>

-1. Resin-

(A) Resin for layer

- Ionomer 1: zinc ionomer of ethylene·methacrylic acid copolymer (content of methacrylic acid unit = 15% by weight) (degree of neutralization: 23%, MFR: 5 g/10 min)
- Ionomer 2: zinc ionomer of ethylene·methacrylic acid·butyl acrylate ternary copolymer (content of methacrylic acid unit = 5% by weight, butyl acrylate: 7% by weight) (degree of neutralization: 10%, MFR: 11 g/10 min)
- Ionomer 3: zinc ionomer of ethylene·methacrylic acid copolymer (content of methacrylic acid unit = 8.5% by weight) (degree of neutralization: 18%, MFR: 6 g/10 min)

(B) Resin for layer

- Ionomer 4: zinc ionomer of ethylene·methacrylic acid·butyl acrylate ternary copolymer (content of methacrylic acid unit = 5% by weight, butyl acrylate: 7% by weight) (degree of neutralization: 10%, MFR: 11 g/10 min)

- Ionomer 5: zinc ionomer of ethylene·methacrylic acid copolymer (content of methacrylic acid unit = 12% by weight) (degree of neutralization: 36%, MFR: 1.5 g/10 min)

-2. Additive-

- Antioxidant: pentaerythritol tetrakis[3-(3,5-di-tert-butyl-4-hydroxyphenyl)propionate] (manufactured by BASF SE, Irganox 1010)
- Ultraviolet absorber: 2-(2H-benzotriazol-2-yl)-4,6-di-tert-penthylphenol
- Light stabilizer: bis(2,2,6,6,-tetramethyl-4-piperidyl)sebacate
- Silane coupling agent: N-(2-aminoethyl)-3-aminopropylmethyl dimethoxysilane

As a stabilizer masterbatch 1 used for an A layer and a B layer, a mixture was used which was prepared by mixing the same resin as the resin for each layer, the antioxidant, the ultraviolet absorber, and the light stabilizer at a weight ratio of resin/antioxidant/ultraviolet absorber/light stabilizer = 93.7/0.3/4/2 and extruding the resultant in advance by using a twin-screw extruder.

As a stabilizer masterbatch 2 used for the layer A and the layer B, a mixture was used which was prepared by mixing the same resin as the resin for each layer, the antioxidant, the light stabilizer at a weight ratio of resin/antioxidant/light stabilizer = 96/2/2 and extruding the resultant in advance by using a twin-screw extruder. As a white masterbatch, a mixture was used which was prepared by mixing together a white masterbatch PE-M 13N4700 manufactured by Dainichiseika Color & Chemicals Mfg. Co., Ltd, the antioxidant, the ultraviolet absorber, and the light stabilizer at a predetermined weight ratio and extruding the resultant in advance by using a twin-screw extruder.

As a stabilizer masterbatch 3 used for the layer A, a mixture was used which was prepared by mixing together an ethylene·α-olefin copolymer (TAFMER-A-4090S manufactured by Mitsui Chemicals, Inc.) as a base resin, the antioxidant, and the light stabilizer at a weight ratio of base resin/antioxidant/light stabilizer = 96/2/2 and extruding the resultant in advance by using a twin-screw extruder.

-3. Formulation-

<A layer>

- (A)-1: ionomer 1/stabilizer masterbatch 1/silane coupling agent = 90/10/0.2
- (A)-2: ionomer 2/stabilizer masterbatch 1/silane coupling agent = 90/10/0.2
- (A)-3: ionomer 2/stabilizer masterbatch 2/silane coupling agent = 90/10/0.2
- (A)-4: ionomer 3/stabilizer masterbatch 1/white masterbatch/silane coupling agent = 85/10/5/0.2
- (A)-5: EVA 1/stabilizer masterbatch 3 = 90/10
- (A)-6: EMA 1/stabilizer masterbatch 3 = 90/10
- (A)-7: EOC 1/stabilizer masterbatch 3 = 90/10
- (A)-8: EOC 2/stabilizer masterbatch 3 = 90/10

(Preparation of EVA 1)

An ethylene·methacrylic acid glycidyl·vinyl acetate copolymer (EGMAVA, manufactured by Sumitomo Chemical Co., Ltd., BONDFAST 7B, ethylene content: 83% by weight, methacrylic acid glycidyl content: 12% by weight, vinyl acetate content: 5% by weight, MFR (190°C, load of 2,160 g): 7 g/10 min): 49.1 parts by weight, an ethylene·vinyl acetate copolymer (vinyl acetate content: 10% by weight): 49.1 parts by weight, 3-methacryloxypropyl trimethoxysilane (manufactured by Shin-Etsu Chemical Co., Ltd., trade name "KBM 503"): 1.5 parts by weight, and 2,5-dimethyl-2,5-di(t-butylperoxy)hexane (manufactured by ARKEMA Yoshitomi, Ltd., trade name "LUPEROX 101"): 0.3 parts by weight were mixed together in advance. Then, by using a 40 mmφ single-screw extruder, EGMAVA and the ethylene·vinyl acetate copolymer were modified by grafting a silane coupling agent 3-methacryloxypropyl trimethoxysilane thereto at a melting temperature of 220°C, thereby obtaining EVA 1 containing ethylene and (meth)acrylic acid glycidyl modified with the silane coupling agent.

(Preparation of EMA 1)

EMA 1 was obtained in the same manner as EVA 1, except that in Preparation of EVA1, EMA: ethylene·methyl methacrylate copolymer (ethylene content: 80% by weight, methyl methacrylate content: 20% by weight) was used instead of the ethylene·vinyl acetate copolymer.

(Preparation of EOC 1)

EOC 1 was obtained in the same manner as EVA 1, except that in Preparation of EVA1, EOC 1: ethylene·α-olefin copolymer (TAFMER-A-4090S manufactured by Mitsui Chemicals, Inc.) was used instead of the ethylene·vinyl acetate copolymer.

(Preparation of EOC 2)

EOC 2 was obtained in the same manner as EVA 1, except that in Preparation of EVA1, EOC 2: ethylene·α-olefin copolymer (TAFMER-H-5030S manufactured by Mitsui Chemicals, Inc.) was used instead of the ethylene·vinyl acetate copolymer.

<B layer>

- (B)-1: ionomer 4/stabilizer masterbatch 1 = 90/10
- (B)-2: ionomer 4/stabilizer masterbatch 2 = 90/10
- (B)-3: ionomer 5/stabilizer masterbatch 1/white masterbatch = 85/10/5
- Resin sheet 1: surface layer (A)-1/interlayer (B)-1/surface layer (A)-1
- Resin sheet 2: surface layer (A)-2/interlayer (B)-1/surface layer (A)-2
- Resin sheet 3: surface layer (A)-3/interlayer (B)-2/surface layer (A)-3
- Resin sheet 4: single layer (A)-3
- Resin sheet 5: surface layer (A)-4/interlayer (B)-3/surface layer (A)-4
- Resin sheet 6: single layer (A)-5
- Resin sheet 7: single layer (A)-6
- Resin sheet 8: single layer (A)-7
- Resin sheet 9: single layer (A)-8
- Resin sheet 10: ethylene-vinyl acetate copolymer-based sealing material (vinyl acetate unit content = 28% by weight)

<Preparation of resin sheet>

The resin sheets 1 to 3 and 5 as multilayer resin sheets were prepared by molding the resins into sheet-like substances at a working temperature of 140°C by using a 2-resin 3-layer type multilayer cast molding machine (manufactured by TANABE PLASTICS MACHINERY CO., LTD.), a FEEDBLOCK system (manufactured by EDI), a 40 mmφ single-screw extruder, and an extruder having a die width of 500 mm respectively.

The resin sheets 4 and 6 to 10 as single layer resin sheets were prepared by molding the resins into a sheet-like substances at a working temperature of 140°C just like the resin sheets 1 to 3 and 5 by using a single layer T-die molding machine (manufactured by TANABE PLASTICS MACHINERY CO., LTD.), a 40 mmφ single-screw extruder, and an extruder having a width of 500 mm respectively.

Furthermore, at the time of preparing a multilayer wiring sheet in which a fluorine-based film or an acryl-based film is used as a base material layer, by supplying the film from a feeding portion of the aforementioned molding machine and heating and compressing the resin sheets 3 and 4 and 6 to 9 by using a nip roll at the time of molding, the multilayer sheet was manufactured.

By using the resin sheets 3 and 4 and 6 to 10, the wiring sheets of examples and comparative examples were prepared. The manufacturing method is as below.

<Example 1>

Fine metal wires having a diameter of 300 μm were arranged at an equal interval on the surface of the resin sheet 3 having a thickness of 100 μm and then heated and compressed, thereby preparing a wiring sheet 1. In the obtained wiring sheet 1, the wires were buried in the resin sheet 3.

<Example 2>

A wiring sheet 2 was prepared by the same method as in Example 1, except that instead of the resin sheet 3, the resin sheet 4 having a thickness of 75 μm and a sheet having a thickness of 25 μm and formed of a tetrafluoroethylene·ethylene copolymer (ETFE) were used. In the obtained wiring sheet 2, the wires were buried in the resin sheet 4.

<Example 3>

A wiring sheet 3 was prepared by the same method as in Example 1, except that instead of the resin sheet 3, the resin sheet 4 having a thickness of 50 μm and a sheet having a thickness of 25 μm and formed of a tetrafluoroethylene·ethylene copolymer (ETFE) were used. In the obtained wiring sheet 3, the wires were buried in the resin sheet 4.

<Example 4>

A wiring sheet 4 was prepared by the same method as in Example 1, except that instead of the resin sheet 3, the resin sheet 4 having a thickness of 25 μm and a sheet having a thickness of 25 μm and formed of a tetrafluoroethylene·ethylene copolymer (ETFE) were used. In the obtained wiring sheet 4, the wires were buried in the resin sheet 4.

<Example 5>

A wiring sheet 5 was prepared by the same method as in Example 1, except that instead of the resin sheet 3, a sheet was used which was obtained by bonding the resin sheet 4 having a thickness of 50 μm to both surfaces of a sheet having a thickness of 50 μm and formed of polymethyl methacrylate (PMMA). In the obtained wiring sheet 5, the wires were buried in the resin sheet 4.

<Example 6>

A wiring sheet 6 was prepared by the same method as in Example 1, except that instead of the resin sheet 3, a sheet was used which was obtained by bonding the resin sheet 6 having a thickness of 60 μm to one surface of a sheet having a thickness of 50 μm and formed of polymethyl methacrylate (PMMA). In the obtained wiring sheet 6, the wires were buried in the resin sheet 6.

<Example 7>

A wiring sheet 7 was prepared by the same method as in Example 1, except that instead of the resin sheet 3, a sheet was used which was obtained by bonding the resin sheet 7 having a thickness of 60 μm to one surface of a sheet having a thickness of 50 μm and formed of polymethyl methacrylate (PMMA). In the obtained wiring sheet 7, the wires were buried in the resin sheet 7.

<Example 8>

A wiring sheet 8 was prepared by the same method as in Example 1, except that instead of the resin sheet 3, a sheet was used which was obtained by bonding the resin sheet 8 having a thickness of 60 μm to one surface of a sheet having a thickness of 50 μm and formed of polymethyl methacrylate (PMMA). In the obtained wiring sheet 8, the wires were buried in the resin sheet 8.

<Example 9>

A wiring sheet 9 was prepared by the same method as in Example 1, except that instead of the resin sheet 3, a sheet was used which was obtained by bonding the resin sheet 9 having a thickness of 60 μm to one surface of a sheet having a thickness of 50 μm and formed of polymethyl methacrylate (PMMA). In the obtained wiring sheet 9, the wires were buried in the resin sheet 9.

<Comparative Example 1>

A wiring sheet 10 was prepared by the same method as in Example 1, except that instead of the resin sheet 3, the resin sheet 10 was used. In the obtained wiring sheet 10, the wires were buried in the resin sheet 10.

Hereinafter, the measurement and the evaluation performed using the obtained wiring sheets 1 to 10 will be described.

·Light transmittance of resin sheet at wavelength of 350 nm: under the condition of 25°C, the light transmittance of the resin sheet at a wavelength of 350 nm was measured based on JIS-K7105. Herein, % was used as the unit.
·Total light transmittance: under the condition of 25°C, the total light transmittance of the resin sheet was measured based on JIS-K7105. Herein, % was used as the unit.
•Shore D hardness: under the condition of room temperature (25°C), the Shore D hardness of the material forming the resin sheet was measured based on JIS-K7125 by using a type D durometer.
·Bending stiffness: based on JIS-K7106, the bending stiffness of the resin sheet was measured using an automatic reading-type "Olsen's stiffness tester" manufactured by Toyo Seiki Seisaku-sho, Ltd. Herein, MPa was used as the unit.

The evaluation results relating to each evaluation item are shown in the following Table 1.

Table 1

| | Evaluation item | | | | | |
|---|---|---|---|---|---|---|
| | Type of base material | Light transmittance at 350 nm (%) | Total light transmittance (%) | Shore D hardness of resin sheet | Thickness of resin sheet | Bending stiffness of resin sheet (MPa) |
| Example 1 (wiring sheet 1) | N/A | 83 | 89.6 | 59 | 100 | 162 |
| Example 2 (wiring sheet 2) | ETFE | 85 | 89.6 | 59 | 75 | 162 |
| Example 3 (wiring sheet 3) | ETFE | 85 | 89.6 | 59 | 50 | 162 |
| Example 4 (wiring sheet 4) | ETFE | 85 | 89.6 | 59 | 25 | 162 |
| Example 5 (wiring sheet 5) | PMMA | 85 | 90.4 | 59 | 50 | 162 |
| Example 6 (wiring sheet 6) | PMMA | 85 | 88.9 | 42 | 60 | 32 |
| Example 7 (wiring sheet 7) | PMMA | 85 | 88.8 | 28 | 60 | 72 |
| Example 8 (wiring sheet 8) | PMMA | 85 | 90.2 | 34 | 60 | 85 |
| Example 9 (wiring sheet 9) | PMMA | 85 | 90.2 | 30 | 60 | 80 |
| Comparative Example 1 (wiring sheet 10) | N/A | 4.3 | 92.2 | 25 | 100 | 9 |

By using the wiring sheets 1 to 10, photovoltaic generation modules were prepare by the method described below.

<Method for preparing photovoltaic generation module>

As shown in the following Table 2, a light-transmitting substrate, a light-receiving surface sealing material (the resin sheets 2, 3, and 10 were used as the sealing material), a wiring sheet, and a photovoltaic generation element were piled up in this order. Then, on the photovoltaic generation element, a wiring sheet, a non-light-receiving surface sealing material (the resin sheets 1, 5, and 10 were used as the sealing material), and a backsheet were piled up in this order, and lamination was performed using a vacuum laminator, thereby preparing the photovoltaic generation modules of Examples 10 to 19 and Comparative Example 2.

Hereinafter, the measurement and the evaluation performed using the obtained photovoltaic generation modules will be specifically described.

Whether or not wire connection is excellent (EL image): whether or not the wire connection in the photovoltaic generation module is excellent was evaluated by an electroluminescence (EL) method. That is, the photovoltaic generation module was caused to emit light by inputting a current to each photovoltaic generation module. In this state, an EL image was captured, and whether or not the wire connection is excellent was evaluated.

For obtaining the EL image of each photovoltaic generation module, an EL image inspection device (manufactured by ITES Co., Ltd, PVX 100) was used. Furthermore, as the measurement conditions for obtaining the EL image, the conditions of a shutter speed of 15 seconds, a stop of 8, an ISO sensitivity of 800, an input voltage of 0.73 V for the photovoltaic generation module, and an input current of 8 A for the photovoltaic generation module were adopted.

By visually checking the obtained EL image, whether or not the wire connection is excellent was evaluated.

Regarding the evaluation results, A means "no shadow (connection is excellent)", and C means "shadow exists (there is a problem in a portion of the wire connection)".

Maximum power (Pmax): the maximum power (Pmax) of the obtained photovoltaic generation modules was measured.

That is, in a state where bias voltage input into each photovoltaic generation module was being varied, the current was measured, and the obtained data was plotted, thereby obtaining an I-V curve (not shown in the drawing).

Herein, for measuring the current, a solar cell IV measurement device NO. M130-DDYTB383 J-JA manufactured by Sumitomo Heavy Industries, Ltd. was used.

The bias voltage was varied within a range of -0.1 V to 0.8 V. Within this range, the bias voltage was varied by 0.02 V up to 0.4 V from -0.1 V and by 0.01 V up to 0.8 V from 0.4 V.

Pmax was measured at 25°C by adopting AM 1.5 g and 1 SUN as the measurement conditions.

Regarding the obtained I-V curve, the point at which the sum of the voltage and the current becomes maximum, that is, "maximum power (Pmax)" was determined.

Fill factor (FF): furthermore, by using the measurement result of the maximum power (Pmax), a fill factor (FF) was determined for the obtained photovoltaic generation modules.

Herein, the current at the time when the voltage is 0 V is referred to as short-circuit current (Isc), and the voltage at the time when a current does not flow in the photovoltaic generation module is referred to as open-circuit voltage (Voc).

The fill factor (FF) was calculated by the following equation.

$$\text{Equation: Fill factor (FF)} = \text{maximum power (Pmax)}/(\text{Voc} \times \text{Isc})$$

The evaluation results relating to the above evaluation items are shown in the following Table 2.

Table 2

| | | Constitution of photovoltaic generation module | | | Evaluation item | | |
|---|---|---|---|---|---|---|---|
| | | Sealing material for light-receiving surface | Wiring sheet | Sealing material for non-light-receiving surface side | Whether or not wire connection is excellent | Maximum power Pmax | Fill factor (FF) |
| | Example 10 | Resin sheet 2 | Wiring sheet 1 | Resin sheet 1 | A | 5.03 | 0.755 |
| | Example 11 | Resin sheet 3 | Wiring sheet 1 | Resin sheet 5 | A | 5.11 | 0.789 |
| | Example 12 | Resin sheet 3 | Wiring sheet 2 | Resin sheet 5 | A | 5.13 | 0.789 |
| | Example 13 | Resin sheet 3 | Wiring sheet 3 | Resin sheet 5 | A | 5.13 | 0.786 |
| | Example 14 | Resin sheet 3 | Wiring sheet 4 | Resin sheet 5 | A | 5.11 | 0.778 |
| | Example 15 | Resin sheet 3 | Wiring sheet 5 | Resin sheet 5 | A | 5.06 | 0.770 |
| | Example 16 | Resin sheet 3 | Wiring sheet 6 | Resin sheet 5 | A | 5.06 | 0.770 |
| | Example 17 | Resin sheet 3 | Wiring sheet 7 | Resin sheet 5 | A | 5.04 | 0.755 |
| | Example 18 | Resin sheet 3 | Wiring sheet 8 | Resin sheet 5 | A | 5.13 | 0.789 |

(continued)

| | Constitution of photovoltaic generation module | | | Evaluation item | | |
|---|---|---|---|---|---|---|
| | Sealing material for light-receiving surface | Wiring sheet | Sealing material for non-light-receiving surface side | Whether or not wire connection is excellent | Maximum power Pmax | Fill factor (FF) |
| Example 19 | Resin sheet 3 | Wiring sheet 9 | Resin sheet 5 | A | 5.13 | 0.789 |
| Comparative Example 2 | Resin sheet 10 | Wiring sheet 10 | Resin sheet 10 | C | 4.82 | 0.743 |

In the photovoltaic generation module of Example 10, a light-receiving surface sealing material containing an ultraviolet absorber was used. Therefore, from the viewpoint of power generation efficiency, this module was slightly poorer than the photovoltaic generation module of Example 11. However, because of including the wiring sheet 1 having the resin sheet 3 formed of a specific resin material (resin material containing ionomer 2), the photovoltaic generation module of Example 10 exhibited excellent wire connection. Furthermore, from the viewpoint of power generation efficiency, the photovoltaic generation module of Example 10 is better than the photovoltaic generation module of Comparative Example 2.

**Claims**

1.   A wiring sheet (100) for a photovoltaic module (300) comprising:

   a resin sheet (10); and
   fine wires (20) provided on one surface of the resin sheet (10),
   wherein a light transmittance of the resin sheet (10) at a wavelength of 350 nm is equal to or higher than 70%, and
   wherein the resin sheet (10) is formed of a resin material containing any of the following (A) and (B):

      (A) ionomer of copolymer containing ethylene and unsaturated carboxylic acid,
      (B) Copolymer containing ethylene and (meth)acrylic acid glycidyl.

2.   The wiring sheet (100) for a photovoltaic module (300) according to claim 1,
   wherein the fine wires (20) are formed of a plurality of wires disposed in parallel with each other.

3.   The wiring sheet (100) for a photovoltaic module (300) according to any one of claims 1 or 2,
   wherein a Shore D hardness under a condition of room temperature of the material forming the resin sheet (10) is higher than 25 and equal to or lower than 200.

4.   The wiring sheet (100) for a photovoltaic module (300) according to any one of claims 1 to 3,
   wherein a portion of the fine wires (20) is buried in the resin sheet (10).

5.   The wiring sheet (100) for a photovoltaic module (300) according to any one of claims 1 to 4,
   wherein the resin sheet (10) has a multilayer structure.

6.   The wiring sheet (100) for a photovoltaic module (300) according to claim 5, further comprising:
   a layer formed of a material containing one or more resins selected from the group consisting of a fluorine resin and an acrylic resin, on a surface of the resin sheet (10) opposite to the surface provided with the fine wires (20).

7.   A structure (200) comprising:

   the wiring sheet (100) for a photovoltaic module (300) according to any one of claims 1 to 6; and
   a sealing material (50) formed of a resin material containing any of the following (A) and (B):

(A) Copolymer containing ethylene and unsaturated carboxylic acid or ionomer of the copolymer
(B) Copolymer containing ethylene and (meth)acrylic acid glycidyl

**8.** The structure (200) according to claim 7,
wherein the sealing material (50) contains a white pigment.

**9.** A photovoltaic generation module (300) comprising:

a light-transmitting substrate (70); and
the wiring sheet (100) for a photovoltaic module according to any one of claims 1 to 6.

**Patentansprüche**

**1.** Verdrahtungsplatte (100) für ein Fotovoltaikmodul (300), umfassend:

eine Harzplatte (10); und
feine Drähte (20), die auf einer Oberfläche der Harzplatte (10) vorgesehen sind,
wobei eine Lichtdurchlässigkeit der Harzplatte (10) bei einer Wellenlänge von 350 nm gleich oder höher als 70 % ist und
wobei die Harzplatte (10) aus einem Harzmaterial ausgebildet ist, das eines aus den folgenden (A) und (B) enthält:

(A) Ionomer eines Copolymers, das Ethylen und ungesättigte Carbonsäure enthält,
(B) Copolymer, das Ethylen und (Meth)acrylsäureglycidyl enthält.

**2.** Verdrahtungsplatte (100) für ein Fotovoltaikmodul (300) nach Anspruch 1,
wobei die feinen Drähte (20) aus einer Mehrzahl von Drähten ausgebildet sind, die parallel zueinander angeordnet sind.

**3.** Verdrahtungsplatte (100) für ein Fotovoltaikmodul (300) nach einem der Ansprüche 1 oder 2,
wobei eine Shore D-Härte des Materials, das die Harzplatte (10) ausbildet, bei Raumtemperatur höher als 25 und gleich oder niedriger als 200 ist.

**4.** Verdrahtungsplatte (100) für ein Fotovoltaikmodul (300) nach einem der Ansprüche 1 bis 3,
wobei ein Teil der feinen Drähte (20) in die Harzplatte (10) eingelassen ist.

**5.** Verdrahtungsplatte (100) für ein Fotovoltaikmodul (300) nach einem der Ansprüche 1 bis 4,
wobei die Harzplatte (10) eine mehrschichtige Struktur aufweist.

**6.** Verdrahtungsplatte (100) für ein Fotovoltaikmodul (300) nach Anspruch 5, ferner umfassend:
eine Schicht, die aus einem Material ausgebildet ist, das ein oder mehrere Harze enthält, die aus der Gruppe bestehend aus einem Fluorharz und einem Acrylharz ausgewählt sind, auf einer Oberfläche der Harzplatte (10) gegenüber der Oberfläche, die mit den feinen Drähten (20) versehen ist.

**7.** Struktur (200), umfassend:

die Verdrahtungsplatte (100) für ein Fotovoltaikmodul (300) nach einem der Ansprüche 1 bis 6; und
ein Versiegelungsmaterial (50), das aus einem Harzmaterial ausgebildet ist, das eines aus den folgenden (A) und (B) enthält:

(A) Copolymer, das Ethylen und ungesättigte Carbonsäure enthält, oder Ionomer des Copolymers,
(B) Copolymer, das Ethylen und (Meth)acrylsäureglycidyl enthält.

**8.** Struktur (200) nach Anspruch 7,
wobei das Versiegelungsmaterial (50) ein weißes Pigment enthält.

**9.** Fotovoltaisches Erzeugungsmodul (300), umfassend:

ein lichtdurchlässiges Substrat (70); und
die Verdrahtungsplatte (100) für ein Fotovoltaikmodul nach einem der Ansprüche 1 bis 6.

**Revendications**

1.  Feuille de câblage (100) pour un module photovoltaïque (300), comprenant :

    une feuille en résine (10) ; et
    fils fins (20) prévus sur une surface de la feuille en résine (10),
    où la transmittance lumineuse de la feuille en résine (10) à une longueur d'onde de 350 nm est égale ou supérieure à 70 %, et
    où la feuille en résine (10) est constituée d'une résine contenant soit (A) soit (B) suivant :

    (A) ionomère copolymère d'éthylène et acide carboxylique insaturé,
    (B) copolymère d'éthylène et glycidyle d'acide (méth)acrylique.

2.  Feuille de câblage (100) pour un module photovoltaïque (300) selon la revendication 1,
    où les fils fins (20) sont constitués d'une pluralité de fils disposés parallèlement entre eux.

3.  Feuille de câblage (100) pour un module photovoltaïque (300) selon la revendication 1 ou la revendication 2,
    où la dureté Shore D à température ambiante du matériau formant la feuille en résine (10) est supérieure à 25 et égale ou inférieure à 200.

4.  Feuille de câblage (100) pour un module photovoltaïque (300) selon l'une des revendications 1 à 3,
    où une partie des fils fins (20) est noyée dans la feuille en résine (10).

5.  Feuille de câblage (100) pour un module photovoltaïque (300) selon l'une des revendications 1 à 4,
    où la feuille en résine (10) a une structure multicouches.

6.  Feuille de câblage (100) pour un module photovoltaïque (300) selon la revendication 5, comprenant en outre :
    une couche constituée d'un matériau contenant une ou plusieurs résines sélectionnées dans le groupe comprenant une résine fluorée et une résine acrylique, sur une surface de la feuille en résine (10) opposée à la surface pourvue de fils fins (20).

7.  Structure (200), comprenant :

    la feuille câblage (100) pour un module photovoltaïque (300) selon l'une des revendications 1 à 6 ; et
    un matériau de scellement (50) constitué d'une résine contenant soit (A) soit (B) suivant :

    (A) copolymère d'éthylène et acide carboxylique insaturé ou ionomère dudit copolymère
    (B) copolymère d'éthylène et glycidyle d'acide (méth)acrylique.

8.  Structure (200) selon la revendication 7,
    où le matériau de scellement (50) contient un pigment blanc.

9.  Module générateur photovoltaïque (300), comprenant :

    un substrat translucide (70) ; et
    la feuille de câblage (100) pour un module photovoltaïque selon l'une des revendications 1 à 6.

FIG.1

100

10

20

FIG.2

100

20

10

FIG.3

200

50

10
100
20

FIG.4

300-1

70

50

400

80

10
100
20

FIG.5

FIG.6

300-2

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2014141542 A
- JP 2011210891 A
- US 20120255610 A1
- WO 2014045909 A1
- US 20050241692 A1
- JP 2005536894 A